# EUROPEAN PATENT APPLICATION

(11) **EP 4 661 601 A1**
(43) Date of publication of application: **10.12.2025**
(21) Application number: 24788872.0
(22) Date of filing: 22.01.2024
(51) Int. Cl.: H05K 1/02, H03H 7/38, H04M 1/02

(54) **ELECTRONIC DEVICE COMPRISING FPCB**

(30) Priority: 11.04.2023 KR 20230047240; 04.05.2023 KR 20230058616
(71) Applicant: Samsung Electronics Co., Ltd., Suwon-si, Gyeonggi-do 16677 (KR)
(72) Inventor: CHO, Hyongrae, Suwon-si, Gyeonggi-do 16677 (KR); KIM, Seunghun, Suwon-si, Gyeonggi-do 16677 (KR); KIM, Jeongseob, Suwon-si, Gyeonggi-do 16677 (KR); LEE, Sangyup, Suwon-si, Gyeonggi-do 16677 (KR); LEE, Seokwoo, Suwon-si, Gyeonggi-do 16677 (KR); HAN, Junhee, Suwon-si, Gyeonggi-do 16677 (KR)
(74) Representative: Gulde & Partner
(86) International application number: PCT/KR2024/001020
(87) International publication number: WO 2024/214928

(57) **Abstract**

An electronic device according to one embodiment of the present invention comprises: a hinge module; a first housing which comprises a first printed circuit board, and at least a portion of which is coupled to a first side of the hinge module; a second housing which comprises a second printed circuit board, and at least a portion of which is coupled to a second side of the hinge module; an FPCB which is arranged to cross the first housing and the second housing via the hinge module, and is configured to electrically connect the first printed circuit board and the second printed circuit board; a first sensor electrically connected to the first printed circuit board so as to detect the folding angle or the unfolding angle of the first housing and the second housing; a second sensor electrically connected to the first printed circuit board so as to detect an impedance change of the FPCB, on the basis of the folding angle or the unfolding angle of the first housing and the second housing; a first tuner arranged on the first printed circuit board so as to compensate for the impedance of the FPCB generated as the first housing and the second housing fold; and a processor operatively connected to the FPCB, the first sensor, the second sensor, and the first tuner, wherein the processor can be configured to compensate for the impedance change of the FPCB by controlling the first tuner on the basis of the folding angle or the unfolding angle of the first housing and the second housing.

## Description

### [Technical Field]

Various embodiments of the disclosure relate to an electronic device (e.g., a foldable electronic device) including a flexible printed circuit board (FPCB).

### [Background Art]

The use of a foldable electronic device, such as a foldable phone or a tablet PC, is increasing, and various functions are being provided in the foldable electronic device.

The foldable electronic device may operate in a folded state or an unfolded state in which a first housing and a second housing are folded or unfolded around a hinge module.

The foldable electronic device may operate in an in-folding and/or out-folding manner by rotating the first housing and the second housing using the hinge module.

### [Disclosure of Invention]

### [Technical Problem]

A foldable electronic device may include a flexible display disposed at least partially across a first housing, a hinge module, and a second housing.

In the foldable electronic device, when the first housing and the second housing are folded using the hinge module, the flexible display may also be folded together, and when the first housing and the second housing are unfolded, the flexible display may also be unfolded together.

In the foldable electronic device, a first printed circuit board, on which a plurality of electronic components are mounted, may be included in an inner space of the first housing, and a second printed circuit board, on which a plurality of electronic components are mounted, may be included in an inner space of the second housing.

The first printed circuit board and the second printed circuit board may be electrically connected by using an FPCB disposed across the first housing and the second housing through the hinge module.

In the foldable electronic device, when the first housing and the second housing operate in a folded state or an unfolded state, a bending angle of the FPCB disposed in the hinge module may change. For example, when the first housing and the second housing transition from the unfolded state to the folded state, layers of the FPCB may become separated due to the bending of the FPCB disposed in the hinge module. For example, when the first housing and the second housing are in the folded state and the layers of the FPCB disposed in the hinge module are separated, impedance of the FPCB may change (e.g., decrease), which may cause a mismatch. When the impedance of the FPCB is mismatched, signal distortion due to reflected waves may occur.

When the first housing and the second housing are in the folded state and the impedance of the FPCB changes, signal stability may deteriorate or communication quality may be degraded in the foldable electronic device.

Various embodiments of the disclosure may provide an electronic device (e.g., a foldable electronic device) configured to compensate for (e.g., correct) the impedance of the FPCB based on an angle of the folded or unfolded state of the first housing and the second housing.

The technical problems to be addressed by this disclosure are not limited to those described above, and other technical problems not mentioned above may be clearly understood by those skilled in the art.

### [Solution to Problem]

According to an embodiment of the disclosure, an electronic device may include a hinge module, a first housing coupled to at least a portion of a first side of the hinge module and including a first printed circuit board, a second housing coupled to at least a portion of a second side of the hinge module and including a second printed circuit board, and a flexible printed circuit board (FPCB) disposed across the first housing and the second housing through the hinge module and configured to electrically connect the first printed circuit board and the second printed circuit board. According to an embodiment, the electronic device may include a first sensor electrically connected to the first printed circuit board to detect a folding angle or an unfolding angle of the first housing and the second housing. According to an embodiment, the electronic device may include a second sensor electrically connected to the first printed circuit board to detect a change in impedance of the FPCB based on the folding angle or the unfolding angle of the first housing and the second housing. According to an embodiment, the electronic device may include a first tuner disposed on the first printed circuit board to compensate for the change in impedance of the FPCB generated by folding of the first housing and the second housing. According to an embodiment, the electronic device may include a processor operatively connected to the FPCB, the first sensor, the second sensor, and the first tuner. According to an embodiment, the processor may be configured to control the first tuner based on the folding angle or the unfolding angle of the first housing and the second housing so as to compensate for the change in impedance of the FPCB.

### [Advantageous Effects of Invention]

According to various embodiments of the disclosure, by compensating for the impedance of the FPCB through a tuner based on an angle of a folded or unfolded state of the first housing and the second housing, signal stability may be ensured regardless of the folded or unfolded state of the first housing and the second housing, and high-speed communication may be performed.

In addition, various effects that are directly or indirectly identified through the various embodiments of the disclosure may be provided.

### [Brief Description of Drawings]

In connection with the description of the drawings, the same or similar components may be denoted by the same or similar reference numerals.
FIG. 1 is a block diagram of an electronic device in a network environment, according to various embodiments of the disclosure.
FIG. 2A is a front perspective view illustrating an electronic device in an unfolded state according to various embodiments of the disclosure.
FIG. 2B is a front view illustrating the electronic device in the unfolded state according to various embodiments of the disclosure.
FIG. 2C is a rear view illustrating the electronic device in the unfolded state according to various embodiments of the disclosure.
FIG. 3A is a perspective view illustrating the electronic device in a folded state according to various embodiments of the disclosure.
FIG. 3B is a front perspective view illustrating the electronic device in an intermediate state according to various embodiments of the disclosure.
FIG. 4 is an exploded perspective view of an electronic device according to various embodiments.
FIG. 5 is a view schematically illustrating some components when an electronic device including an FPCB is in an unfolded state, according to an embodiment of the disclosure.
FIG. 6 is a view schematically illustrating some components when an electronic device including an FPCB and a BTB connector is in an unfolded state, according to an embodiment of the disclosure.
FIG. 7 is a view schematically illustrating some components when an electronic device including an FPCB and at least one IC is in an unfolded state, according to an embodiment of the disclosure.
FIG. 8A is a view schematically illustrating some components in which a first sensor of an electronic device according to an embodiment of the disclosure is a gear counter.
FIG. 8B is a view illustrating an example in which the first sensor according to an embodiment of the disclosure is disposed in a first housing.
FIG. 9A is a view schematically illustrating some components in which a first sensor disposed in a first housing of an electronic device according to an embodiment of the disclosure is a Hall sensor, and a magnet is disposed in a second housing.
FIG. 9B is a view illustrating an example in which the first sensor according to an embodiment of the disclosure is disposed in the first housing and the magnet is disposed in the second housing.
FIG. 10A is a view schematically illustrating some components in which a first sensor of an electronic device according to an embodiment of the disclosure is an image sensor.
FIG. 10B is a view illustrating an example in which the first sensor according to an embodiment of the disclosure is disposed in a first housing.
FIG. 11A is a view schematically illustrating some components of an electronic device including a first tuner and/or a second tuner according to an embodiment of the disclosure.
FIG. 11B is an enlarged view schematically illustrating the configurations of the first tuner and the second tuner illustrated in FIG. 11A according to an embodiment of the disclosure.
FIG. 12 is a view schematically illustrating some components of an electronic device including a first tuner and/or a second tuner according to an embodiment of the disclosure.
FIG. 13 is a view schematically illustrating some components of an electronic device including a repeater according to an embodiment of the disclosure.

### [Mode for the Invention]

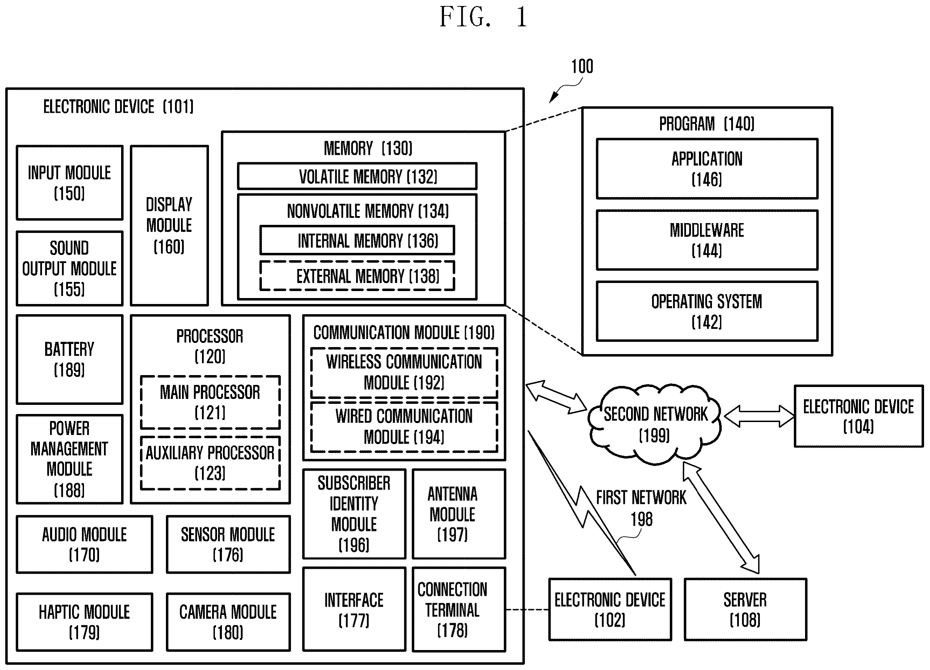

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

According to various embodiments, the interface 177 may electrically or operatively connect components in the electronic 101. For example, the interface 177 may include a mobile industry processor interface (MIPI), a universal flash storage (UFS) interface or a peripheral component interconnect express (PCIe) interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively," as "coupled with," "coupled to," "connected with," or "connected to" another element (e.g., a second element), it denotes that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

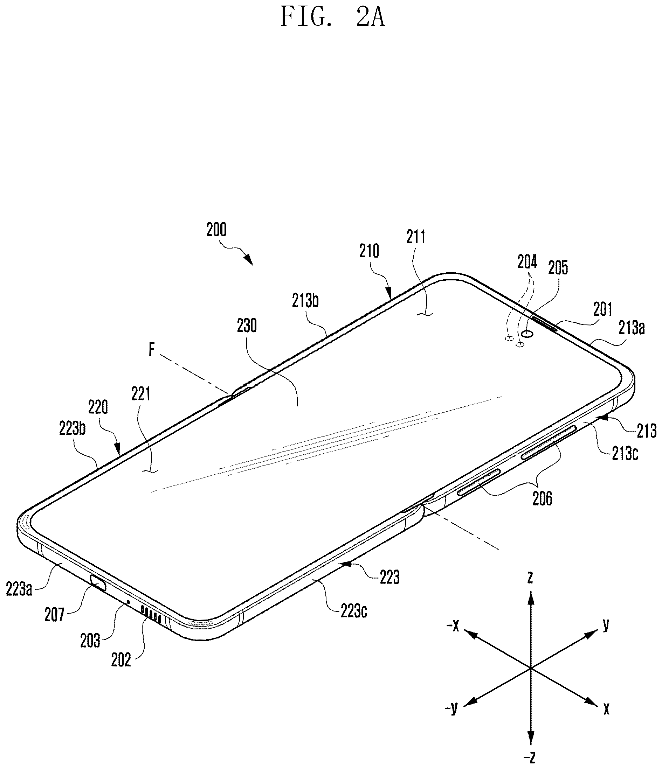

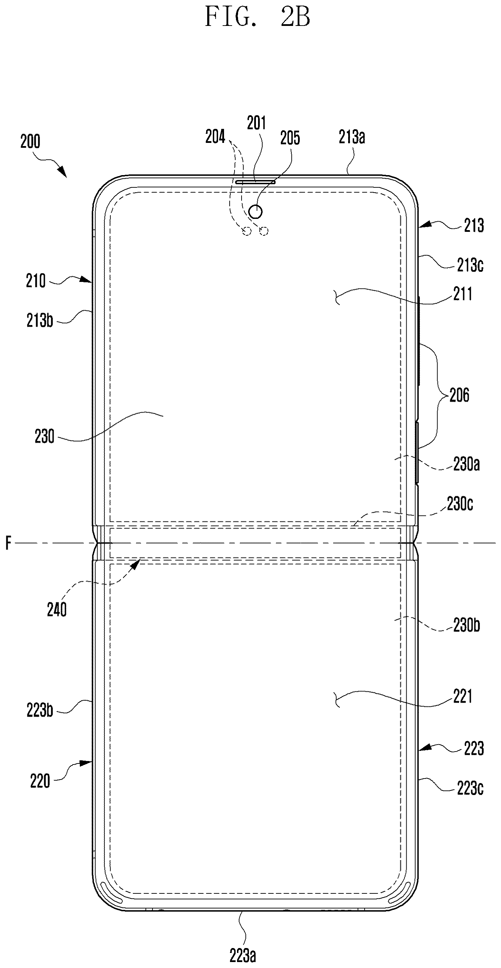

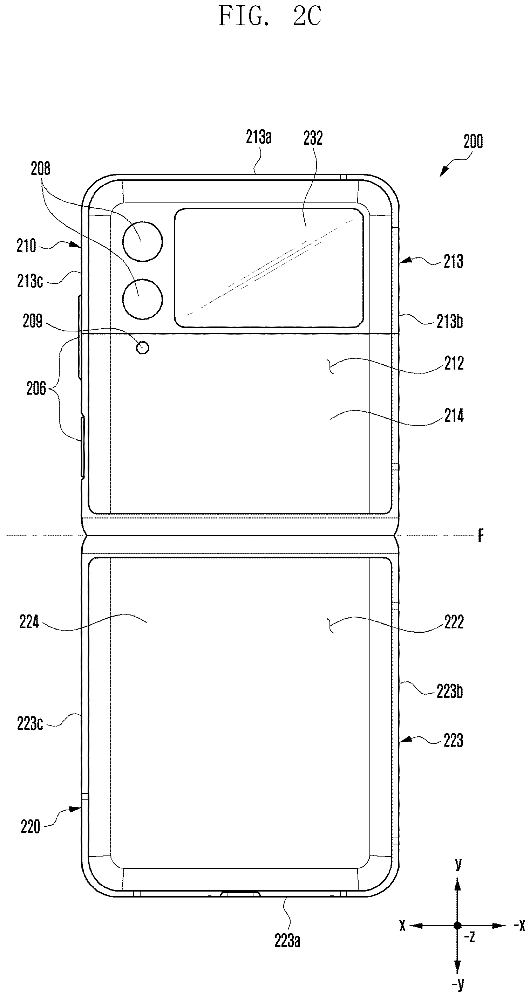

FIG. 2A is a front perspective view illustrating an electronic device in an unfolded state according to various embodiments of the disclosure. FIG. 2B is a front view illustrating the electronic device in the unfolded state according to various embodiments of the disclosure. FIG. 2C is a rear view illustrating the electronic device in the unfolded state according to various embodiments of the disclosure.

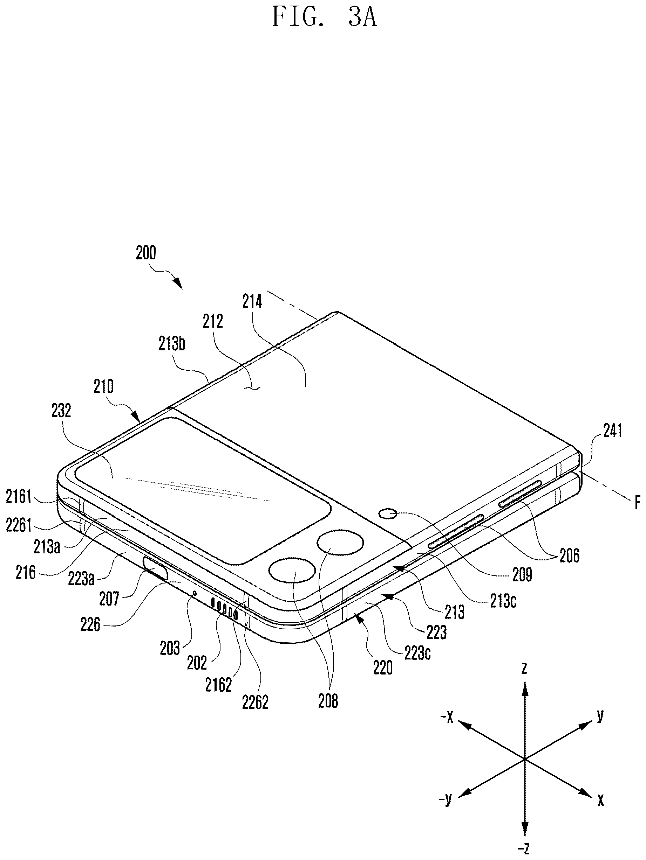

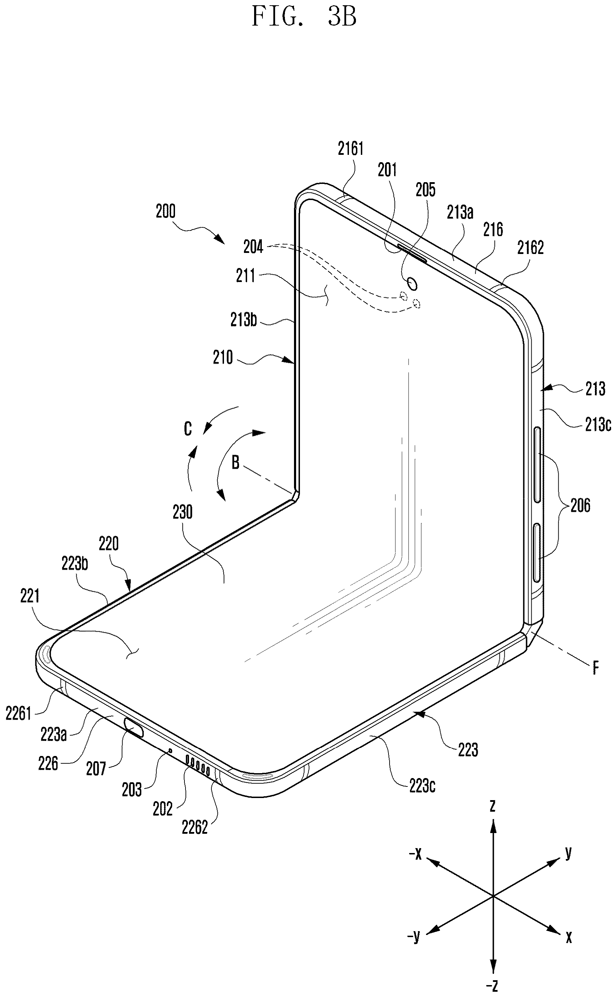

FIG. 3A is a perspective view illustrating the electronic device in a folded state according to various embodiments of the disclosure. FIG. 3B is a front perspective view illustrating the electronic device in an intermediate state according to various embodiments of the disclosure.

The electronic device 200 (e.g., the electronic device 101 of FIG. 1) illustrated in FIGS. 2A to 3B may include, for example, a foldable electronic device that folds or unfolds in a vertical direction. Although various embodiments of the disclosure will be described based a foldable electronic device that folds or unfolds in the vertical direction, the same embodiments may also be applied to a foldable electronic device that folds or unfolds in the horizontal direction.

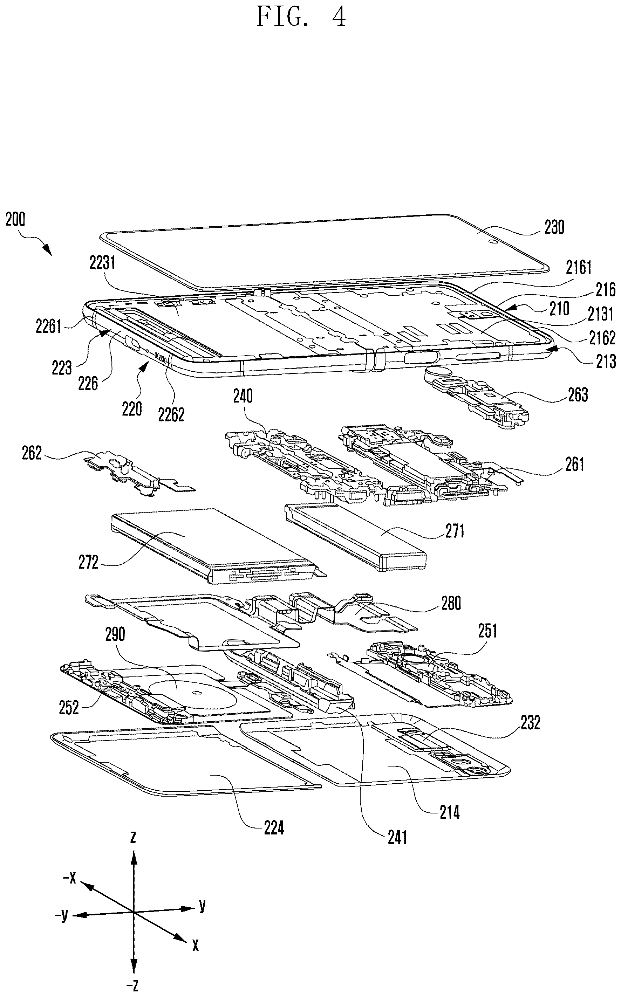

Referring to FIGS. 2A to 3B, the electronic device 200 (e.g., the electronic device 101 of FIG. 1) according to various embodiments of the disclosure may include a pair of housings (e.g., a first housing 210 and a second housing 220) (e.g., foldable housings) that are foldable toward each other about a hinge module 240 (e.g., the hinge module 240 of FIG. 2B or FIG. 4). In some embodiments, the hinge module 240 (e.g., the hinge module 240 of FIG. 2B or FIG. 4) may be disposed in the x-axis direction (e.g., horizontal direction) or in the y-axis direction (e.g., vertical direction). In some embodiments, two or more hinge modules 240 may be arranged to be folded in the same direction or in different directions.

According to various embodiments, the electronic device 200 may include a flexible display 230 (e.g., a foldable display) disposed in an area defined by the pair of housings 210 and 220. The first housing 210 and the second housing 220 are disposed on opposite sides of a folding axis (the axis F), and may have substantially symmetrical shapes with respect to the folding axis (the axis F). The first housing 210 and the second housing 220 may vary in angle or distance from each other depending on whether the electronic device 200 is in an unfolded (unfolding or flat) state, a folded state, or an intermediate state.

According to various embodiments, the pair of housings 210 and 220 may include a first housing 210 (e.g., a first housing structure) coupled to a first side of the hinge module 240 (e.g., the hinge module 240 of FIG. 2B or FIG. 4) and a second housing 220 (e.g., a second housing structure) coupled to a second side of the hinge module 240. The first housing 210 may include a first surface 211 oriented in a first direction (e.g., a forward (z-axis) direction) and a second surface 212 oriented in a second direction (e.g., a rearward (-z-axis) direction) opposite to the first direction in the unfolded state. The second housing 220 may include a third surface 221 oriented in the first direction (e.g., the forward (z-axis) direction) and a fourth surface 222 oriented in the second direction (e.g., a rearward (-z-axis) direction) in the unfolded state.

According to an embodiment, the electronic device 200 may be operated such that, in the unfolded state, the first surface 211 of the first housing 210 and the third surface 221 of the second housing 220 face substantially the same direction, i.e., the first direction (e.g., the z-axis direction) and in the folded state, the first surface 211 and the third surface 221 face each other. The electronic device 200 may be operated such that, in the unfolded state, the second surface 212 of the first housing 210 and the fourth surface 222 of the second housing 220 are oriented in substantially the same second direction (e.g., the -z-axis direction), and, in the folded state, the second surface 212 and the fourth surface 222 face away from each other. For example, in the folded state, the second surface 212 of the first housing 210 may be oriented in the first direction (e.g., the z-axis direction), and the fourth surface 222 of the second housing 220 may be oriented in the second direction (e.g., the -z-axis direction).

According to various embodiments, the first housing 210 may include a first side surface frame 213 configured to define at least a portion of the exterior of the electronic device 200 and a first rear surface cover 214 coupled to the first side surface frame 213 and configured to define at least a portion of the second surface 212 of the electronic device 200. The first side surface frame 213 may include a first side surface 213a, a second side surface 213b extending from one end of the first side surface 213a, and a third side face 213c extending from the other end of the first side surface 213a. The first side surface frame 213 may be configured in a rectangular (e.g., square or oblong) shape with the first side surface 213a, the second side surface 213b, and the third side surface 213c.

According to various embodiments, the second housing 220 may include a second side surface frame 223 configured to define at least a portion of the exterior of the electronic device 200 and a second rear surface cover 224 coupled to the second side surface frame 223 and configured to define at least a portion of the fourth surface 222 of the electronic device 200. The second side surface frame 223 may include a fourth side surface 223a, a fifth side surface 223b extending from one end of the fourth side surface 223a, and a sixth side surface 223c extending from the other end of the fourth side surface 223a. The second side surface frame 223 may be formed in a rectangular (e.g., square or oblong) shape by the fourth side surface 223a, the fifth side surface 223b, and the sixth side surface 223c.

According to various embodiments, the pair of housings 210 and 220 are not limited to the illustrated shape and assembly, but may be implemented with other shapes or combinations and/or assemblies of components. For example, the first side surface frame 213 may be integrally formed with the first rear surface cover 214, and the second side surface frame 223 may be integrally formed with the second rear surface cover 224.

According to various embodiments, when the electronic device 200 is in the unfolded state, the second side surface 213b of the first side surface frame 213 and the fifth side surface 223b of the second side surface frame 223 may be connected to each other without substantially no gap. When the electronic device 200 is in the unfolded state, the third side surface 213c of the first side surface frame 213 and the sixth side surface 223c of the second side surface frame 223 may be connected to each other without substantially no gap. In an embodiment, the electronic device 200 may be configured such that, in the unfolded state, a total length of the second side surface 213b and the fifth side surface 223b is greater than the length of the first side surface 213a and/or the fourth side surface 223a. The electronic device 200 may be configured such that a total length of the third side surface 213c and the sixth side surface 223c is longer than the length of first side surface 213a and/or the length of the fourth side surface 223a.

According to various embodiments, the first side surface frame 213 and/or the second side surface frame 223 may include metal or polymer. In an embodiment, the first side surface frame 213 and/or the second side surface frame 223 may include at least one conductive portion 216 and/or 226 (e.g., an antenna radiator) electrically isolated by one or more polymer-based segmentation portions 2161 and 2162 and/or 2261 and 2262. In this case, the at least one conductive portion 216 and/or 226 may be used as a first antenna and/or a second antenna operating in at least one designated band (e.g., a legacy band) by being electrically connected to a wireless communication module (e.g., the wireless communication module 192 of FIG. 1) disposed on a printed circuit board (e.g., the first board assembly 261 of FIG. 4) of the electronic device 200.

According to various embodiments, the first rear surface cover 214 and/or the second rear surface cover 224 may be formed of at least one of, for example, coated or colored glass, ceramic, polymer, or metal (e.g., aluminum, stainless steel (STS), or magnesium), or a combination of at least two of these materials.

According to various embodiments, the flexible display 230 may be disposed to extend from the first surface 211 of the first housing 210 to at least a portion of the third surface 221 of the second housing 220 across the hinge module 240 (e.g., the hinge module 240 of FIG. 2B). For example, the flexible display 230 may substantially include a first planar area 230a corresponding to the first surface 211, a second planar area 230b corresponding to the second surface 212, and a folding area 230c (e.g., a bending area) interconnecting the first planar area 230a and the second planar area 230b and corresponding to the hinge module 240 (e.g., the hinge module 240 of FIG. 2B or FIG. 4).

According to an embodiment, the flexible display 230 may include a unbreakable (UB) type OLED display (e.g., a curved display). However, the flexible display 230 is not limited thereto and may also include a flat type display based on an on-cell touch active matrix organic light-emitting diode (OCTA AMOLED).

According to various embodiments, an edge (e.g., an outer surface) of the first planar area 230a of the flexible display 230 may be disposed on an inner surface of the first housing 210. An edge (e.g., an outer surface) of the second planar area 230b of the flexible display 230 may be disposed on an inner surface of the second housing 220. The edge of the flexible display 230 may be protected by a protective cap (not illustrated) disposed in an area corresponding to the hinge module 240 (e.g., the hinge module 240 of FIG. 2B or FIG. 4). The protective cap (not illustrated) may be optionally included or omitted depending on the specifications of the electronic device 200.

According to various embodiments, the electronic device 200 may include a hinge housing 241 (e.g., a hinge cover). The hinge housing 241 may support the hinge module 240 (e.g., the hinge module 240 of FIG. 2B or FIG. 4), and may be exposed to the outside when the electronic device 200 is in the folded state, and may be received in a first space (e.g., an inner space of the first housing 210) and a second space (e.g., an inner space of the second housing 220) when the electronic device 200 is in the unfolded state, so as to be substantially invisible from the outside. In some embodiments, the flexible display 230 may be disposed to extend from at least a portion of the second surface 212 to at least a portion of the fourth surface 222. In this case, the electronic device 200 may be foldable such that the flexible display 230 is visually exposed to the outside (e.g., out-folding type).

According to various embodiments, the electronic device 200 may include a sub-display 232 disposed separately from the flexible display 230. The sub-display 232 may be disposed to be at least partially visually exposed on the second surface 212 of the first housing 210, and may display status information of the flexible display 230 when the electronic device 200 is in the folded state. The sub-display 232 may be disposed to be visible from the outside through at least a portion of the first rear surface cover 214. In some embodiments, the sub-display 232 may be disposed on the fourth surface 222 of the second housing 220. In this case, the sub-display 232 may be disposed to be visible from the outside through at least a portion of the second rear cover 224.

According to various embodiments, the electronic device 200 may include at least one of an input module 203 (e.g., a microphone), sound output modules 201 and 202, a sensor module 204, camera modules 205 and 208, key input devices 206, or a connector port 207. In the illustrated embodiment, the input module 203 (e.g., a microphone), the sound output modules 201 and 202, the sensor module 204, the camera devices 205 and 208, the key input devices 206, or the connector port 207 are indicated as holes or shapes provided in the first housing 210 or the second housing 220, but may be defined as including actual electronic components (e.g., an input module, a sound output module, a sensor module, or a camera module) disposed inside the electronic device 200 and operating through the holes or shapes.

According to various embodiments, the input module 203 may include at least one microphone disposed in the second housing 220. In some embodiments, the input module 203 may include a plurality of microphones arranged to detect the direction of sound. In some embodiments, the plurality of microphones may be disposed at predetermined positions of the first housing 210 and/or the second housing 220. The input module 203 may include the input module 150 illustrated in FIG. 1. The sound output modules 201 and 202 may include speakers. The sound output modules 201 and 202 may include a receiver 201 for calls disposed in the first housing 210 and a speaker 202 disposed in the second housing 220. The sound output modules 201 and 202 may include the sound output module 155 illustrated in FIG. 1. In some embodiments, the input module 203, the sound output modules 201 and 202, and the connector port 207 may be disposed in a space provided in the first housing 210 and/or a space provided in the second housing 220 of the electronic device 200, and may be exposed to the outside through one or more holes provided in the first housing 210 and/or the second housing 220. At least one connector port 207 may be used to transmit/receive power and/or data to/from an external electronic device. The at least one connector port 207 may include the interface 177 and/or the connection terminal 178 illustrated in FIG. 1. In some embodiments, at least one connector port (e.g., an ear jack hole) may accommodate a connector (e.g., an ear jack) for transmitting/receiving an audio signal to/from an external electronic device. In some embodiments, the holes formed in the first housing 210 and/or the second housing 220 may be commonly used for the input module 203 and the sound output modules 201 and 202. In some embodiments, the sound output modules 201 and 202 may include a speaker that operates without holes formed in the first housing 210 and/or the second housing 220 (e.g., a piezo speaker).

According to various embodiments, the sensor module 204 (e.g., the sensor module 176 of FIG. 1) may generate an electrical signal or a data value corresponding to an internal operating state or an external environmental condition of the electronic device 200. The sensor module 204 may detect an external environment through, for example, the first surface 211 of the first housing 210. In some embodiments, the electronic device 200 may further include at least one sensor module disposed to detect an external environment through the second surface 212 of the first housing 210. The sensor module 204 (e.g., an illuminance sensor) may be disposed under the flexible display 230 to detect an external environment through the flexible display 230. The sensor module 204 may include at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, an illuminance sensor, a proximity sensor, a biometric sensor, or an ultrasonic sensor.

According to various embodiments, the camera modules 205 and 208 may include a first camera module 205 disposed on the first surface 211 of the first housing 210 (e.g., a front camera device) and a second camera module 208 disposed on the second surface 212 of the first housing 210. The electronic device 200 may further include a flash 209 disposed near the second camera module 208. The camera modules 205 and 208 may include one or more lenses, an image sensor, and/or an image signal processor. The flash 209 may include, for example, a light-emitting diode or a xenon lamp. The camera modules 205 and 208 may be arranged such that two or more lenses (e.g., a wide-angle lens, an ultra-wide-angle lens, or a telephoto lens) and image sensors are located on one surface (e.g., the first surface 211, the second surface 212, the third surface 221, or the fourth surface 222) of the foldable electronic device 200. The camera modules 205 and 208 may each include the camera module 180 illustrated in FIG. 1. In some embodiments, the camera modules 205 and 208 may each include time-of-flight (TOF) lenses and/or an image sensor.

According to various embodiments, the key input device 206 (e.g., a key button) may be disposed on the third side surface 213c of the first side frame 213 of the first housing 210. In some embodiments, the key input devices 206 may be disposed on at least one of the other side surfaces 213a and 213b of the first housing 210 and/or the side surfaces 223a, 223b, and 223c of the second housing 220. In some embodiments, the electronic device 200 may not include some or all of the key input devices 206, and key input devices 206 not included in the electronic device 220 may be implemented in another form such as soft keys on the flexible display 230. In some embodiments, the key input devices 206 may be implemented by using pressure sensors included in the flexible display 230.

According to various embodiments, some of the camera modules 205 and 208 (e.g., the first camera module 205) or the sensor module 204 may be disposed to be exposed through the flexible display 230. For example, the first camera module 205 or the sensor module 204 may be disposed in an inner space of the electronic device 200 (e.g., a foldable electronic device) to come into contact with the external environment through an opening (e.g., a through-hole) at least partially formed in the flexible display 230. Some sensor modules 204 may be disposed to perform their functions in the inner space of the electronic device 200 without being visually exposed through the flexible display 230. In this case, an opening may not be required in an area facing the sensor module of the flexible display 230.

Referring to FIG. 3B, the electronic device 200 may be operated to maintain an intermediate folding state through the hinge module 240 (e.g., the hinge module 240 of FIG. 2B or FIG. 4). In this case, the electronic device 200 may control the flexible display 230 such that different content is displayed on a display area corresponding to the first surface 211 (e.g., the first planar area 230a) and a display area corresponding to the third surface 221 (e.g., the second planar area 230b). The electronic device 200 may be operated in a substantially unfolded state (e.g., the unfolded state of FIG. 2A) and/or a substantially folded state (e.g., the folded state of FIG. 3A) based on a predetermined inflection angle (e.g., the angle between the first housing 210 and the second housing 220 in the intermediate folding state) through the hinge module 240. For example, when pressure is applied in an unfolding direction (direction B) while the electronic device 200 is in a state unfolded to the predetermined inflection angle through the hinge module 240, the electronic device 200 may be operated to be in the unfolded state (e.g., the unfolded state of FIG. 2A). For example, when pressure is applied in a folding direction (direction C) while the electronic device 200 is in a state unfolded to the predetermined inflection angle through the hinge module 240, the electronic device 200 may be operated to be in the folded state (e.g., the folded state of FIG. 3A). The electronic device 200 may be operated to maintain a folded or unfolded state at various angles through the hinge module 240.

FIG. 4 is an exploded perspective view of an electronic device (e.g., a foldable electronic device) according to various embodiments of the disclosure.

Referring to FIG. 4, the electronic device 200 (e.g., the electronic device 101 of FIG. 1) may include a first side surface frame 213 of a first housing 210, a second side surface frame 223 of a second housing 220, and a hinge module 240 (e.g., the hinge module 240 of FIG. 2B) rotatably connecting the first side surface frame 213 and the second side surface frame 223.

According to an embodiment, the electronic device 200 may include a first support plate 2131 extending at least partially from the first side surface frame 213 of the first housing 210, and a second support plate 2231 extending at least partially from the second side surface frame 223 of the second housing 220. The first support plate 2131 may be integrally formed with or structurally coupled to the first side surface frame 213. The second support plate 2231 may be integrally formed with or structurally coupled to the second side surface frame 223. The electronic device 200 may include a flexible display 230 arranged to be supported by the first support plate 2131 and the second support plate 2231.

According to an embodiment, the electronic device 200 may include a first rear surface cover 214 coupled to the first side surface frame 213 of the first housing 210 and configured to provide a first space between the first rear surface cover 214 and the first support plate 2131, and a second rear surface cover 224 coupled to the second side surface frame 223 of the second housing 220 and configured to provide a second space between the second rear surface cover 224 and the second support plate 2231. In some embodiments, the first side surface frame 213 and the first rear surface cover 214 may be integrally formed. In some embodiments, the second side surface frame 223 and the second rear surface cover 224 may be integrally formed.

According to an embodiment, the electronic device 200 may include a first housing 210 (e.g., the first housing 210 of FIG. 2A) provided by the first side surface frame 213, the first support plate 2131, and the first rear surface cover 214. The electronic device 200 may include a second housing 220 (e.g., the second housing 220 of FIG. 2A) provided by the second side surface frame 223, the second support plate 2231, and the second rear surface cover 224. The electronic device 200 may include a sub-display 232 arranged to be visible from the outside through at least a portion of the first rear surface cover 214.

According to various embodiments, the electronic device 200 may include a first board assembly 261 (e.g., a main printed circuit board), a camera assembly 263, a first battery 271, or a first bracket 251 disposed in the first space between the first side surface frame 213 and the first rear surface cover 214.

According to an embodiment, the camera assembly 263 may include a plurality of camera modules (e.g., the camera modules 205 and 208 of FIGS. 2A and 3A) and may be electrically connected to the first board assembly 261 (e.g., a first printed circuit board). The first bracket 251 may provide a support structure configured to support the first board assembly 261 and/or the camera assembly 263.

According to an embodiment, the electronic device 200 may include a second board assembly 262 (e.g., a sub printed circuit board), an antenna 290 (e.g., a coil member), a second battery 272, or a second bracket 252 disposed in the second space between the second side surface frame 223 and the second rear surface cover 224.

According to an embodiment, the electronic device 200 may include a wiring member 280 (e.g., a flexible printed circuit board (FPCB)) disposed to extend from the first board assembly 261 across the hinge module 240 to a plurality of electronic components (e.g., the second board assembly 262 (e.g., a second printed circuit board), the second battery 272, or the antenna 290) disposed between the second side surface frame 223 and the second rear surface cover 224 and to provide an electrical connection. The antenna 290 may include a near field communication (NFC) antenna, a wireless charging antenna, and/or a magnetic secure transmission (MST) antenna. For example, the antenna 290 may execute short-range communication with an external device or may transmit/receive power required for charging to/from an external device in a wireless manner.

According to various embodiments, the electronic device 200 may include a hinge housing 241 (e.g., a hinge cover) configured to support or cover the hinge module 240. The hinge housing 241 is exposed to the outside when the electronic device 200 is in the folded state (e.g., the folded state of FIG. 3A), and is at least partially retracted into the first space and/or the second space when the electronic device 200 is in the unfolded state (e.g., the unfolded state of FIG. 2A) so as to be invisible from the outside.

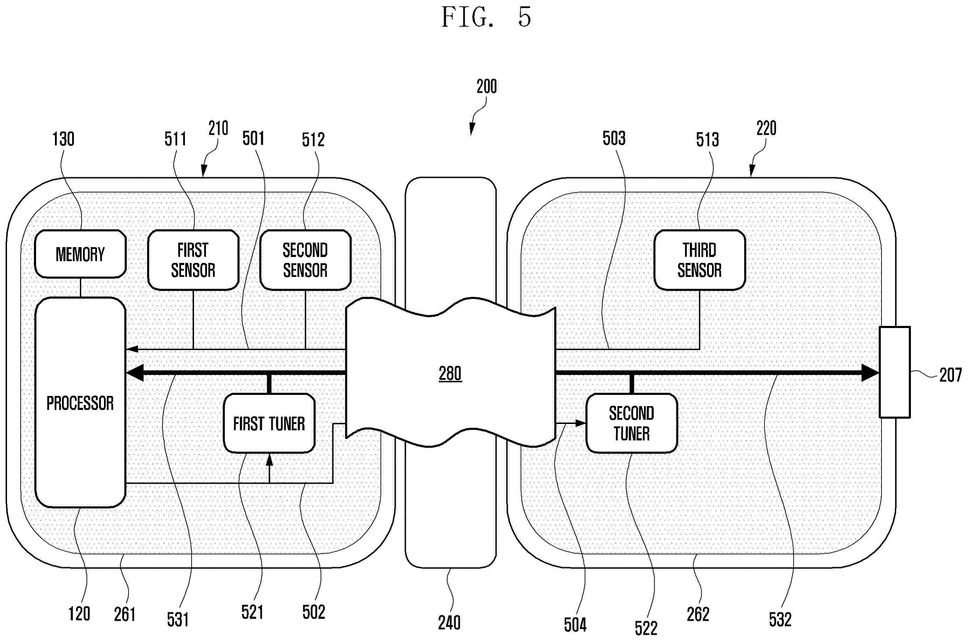

FIG. 5 is a view schematically illustrating some components when an electronic device (e.g., a foldable electronic device) including an FPCB is in an unfolded state, according to an embodiment of the disclosure.

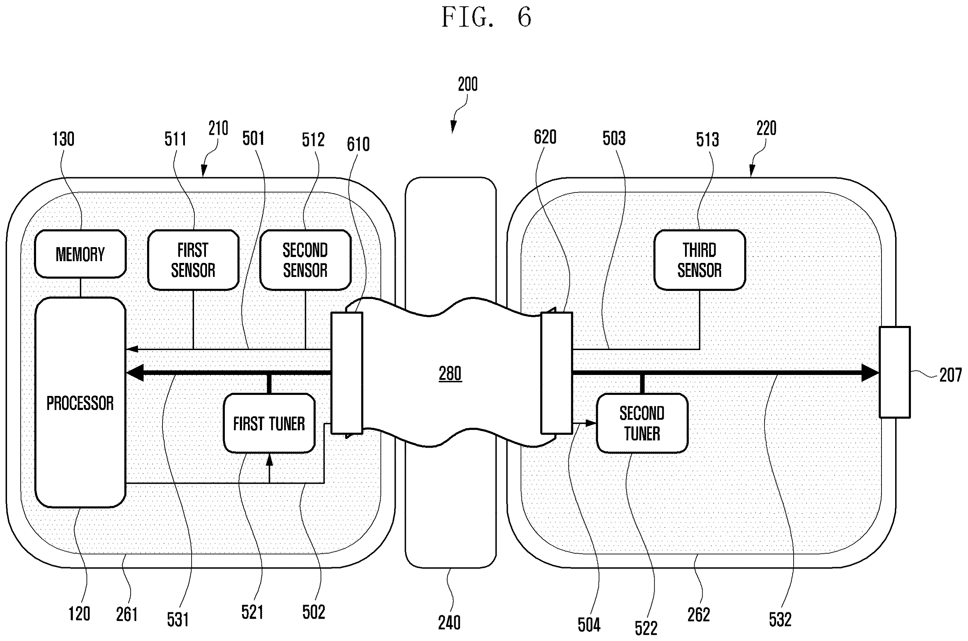

According to various embodiments, the drawings illustrated in FIG. 5 and the subsequent drawings (e.g., FIGS. 6 to 13) may be views schematically illustrating some components of the electronic device 200 before the flexible display 230 is coupled in the electronic device 200 of FIG. 2A, FIG. 2B, FIG. 3B, and/or FIG. 4 according to various embodiments of the disclosure.

According to various embodiments, the electronic device 200 disclosed below (e.g., the foldable electronic device disclosed in FIGS. 5 to 13) may include at least some of the embodiments of the electronic devices 101 and 200 illustrated in FIGS. 1 to 4. In the following descriptions of various embodiments of the disclosure, components that are substantially the same as those illustrated in FIGS. 1 to 4 above may be assigned the same reference numerals, and redundant descriptions of their functions may be omitted.

Referring to FIG. 5, an electronic device 200 (e.g., a foldable electronic device) according to an embodiment of the disclosure may include a first housing 210, a second housing 220, a hinge module 240, an FPCB 280, and/or a connector 207.

According to an embodiment, the first housing 210 may be at least partially coupled to a first side of the hinge module 240. The first housing 210 may be configured to be foldable and unfoldable with the second housing 220 about the hinge module 240. The first housing 210 may include a first printed circuit board 261. The first printed circuit board 261 may include the first board assembly 261 illustrated in FIG. 4.

According to an embodiment, the first printed circuit board 261 may be disposed inside the first housing 210. The first printed circuit board 261 may include a first sensor 511, a second sensor 512, a first tuner 521, a memory 130, and/or a processor 120. For example, the first sensor 511, the second sensor 512, the processor 120, and the FPCB 280 may be electrically connected via a first connection path 501. For example, the first tuner 521, the processor 120, and the FPCB 280 may be electrically connected via a second connection path 502. For example, the first tuner 521, the processor 120, and the FPCB 280 may be electrically connected via a first signal path 531 and may transmit and/or receive a signal.

According to an embodiment, the first sensor 511 may be configured to detect a folding angle and/or an unfolding angle between the first housing 210 and the second housing 220. The first sensor 511 may be configured to detect an angle (e.g., a rotation angle) corresponding to the folded state and/or the unfolded state of the first housing 210 and the second housing 220 with respect to the hinge module 240. The first sensor 511 may be configured to deliver the detected folding angle and/or unfolding angle of the first housing 210 and the second housing 220 to the processor 120. For example, the first sensor 511 may include at least one of a motion sensor, a gear counter, an image sensor, and a Hall sensor. For example, when the first sensor 511 is a motion sensor, the folding angle and/or the unfolding angle of the first housing 210 and the second housing 220 may be calculated based on gravitational acceleration corresponding to the folded state and/or the unfolded state.

According to an embodiment, the second sensor 512 may be configured to detect an impedance change (e.g., an amount of change) of the FPCB 280 based on the folding angle and/or the unfolding angle between the first housing 210 and the second housing 220. The second sensor 512 may be configured to deliver the detected impedance change of the FPCB 280 to the processor 120. For example, the second sensor 512 may include an impedance detection circuit configured to detect a change in impedance of the FPCB 280 based on the folding angle and/or the unfolding angle between the first housing 210 and the second housing 220.

According to an embodiment, the first tuner 521 may be configured to compensate for (e.g., correct) an impedance of the FPCB 280 under control of the processor 120. The first tuner 521 may be configured to compensate for a change in impedance of the FPCB 280 caused by folding of the first housing 210 and the second housing 220. For example, the first tuner 521 may include at least one matching element (e.g., a capacitor and/or an inductor). The first tuner 521 may be configured to match an impedance difference of the FPCB 280 caused by folding of the first housing 210 and the second housing 220. The first tuner 521 may be disposed between the FPCB 280 and the processor 120. The first tuner 521 may be disposed adjacent to the FPCB 280 as compared to the first sensor 511, the second sensor 512, and the processor 120.

According to an embodiment, the memory 130 may be configured to store a matching value capable of matching an impedance difference of the FPCB 280 caused by folding of the first housing 210 and the second housing 220 and/or a configured value for compensating so as to maintain signal quality. The memory 130 may be configured to store a configured value related to a matching value and/or a compensation value capable of matching a mismatch in impedance of the FPCB 280 based on the folding angle and/or the unfolding angle of the first housing 210 and the second housing 220. The memory 130 may be configured to store a table related to a matching value and/or a configured value for compensating for an impedance of the FPCB 280 based on the folding angle and/or the unfolding angle of the first housing 210 and the second housing 220.

According to various embodiments, the memory 130 may be configured to perform a function of storing a program (e.g., the program 140 of FIG. 1), an operating system (e.g., the operating system 142 of FIG. 1), various applications, and input/output data for processing and control of the processor 120. The memory 130 may be configured to store a program for controlling overall operations of the electronic device 200. The memory 130 may be configured to store various configured information necessary for function processing in the electronic device 200.

According to an embodiment, the processor 120 may be operatively connected to the first sensor 511, the second sensor 512, the first tuner 521, and the memory 130, which are disposed on the first printed circuit board 261. The processor 120 may be operatively connected to the third sensor 513, the second tuner 522, and the connector 207 (e.g., a USB connector), which are disposed on the second printed circuit board 262. The processor 120 may be configured to control functions and operations of the first tuner 521 and/or the second tuner 522 based on at least one instruction stored in the memory 130. The processor 120 may be configured to control the first tuner 521 and/or the second tuner 522 based on the folding angle and/or the unfolding angle of the first housing 210 and the second housing 220, so as to compensate for a change in impedance of the FPCB 280. The processor 120 may be configured to calculate a difference in angles between the first sensor 511 (e.g., a first motion sensor) and the third sensor 513 (e.g., a second motion sensor), and to estimate the folding angle and/or the unfolding angle of the first housing 210 and the second housing 220. According to various embodiments, the first sensor 511 and/or the second sensor 512 may be electrically connected to the first printed circuit board 261. The third sensor 513 may be electrically connected to the second printed circuit board 262.

According to various embodiments, the processor 120 may be configured to perform a function of controlling overall operations of the electronic device 101 or 200, controlling signal flows among internal components, and processing data. The processor 120 (e.g., the processor 120 of FIG. 1) may include at least one of a central processing unit (CPU), an application processor, and a communication processor. The processor 120 may include a single-core processor or a multi-core processor. The processor 120 may be configured with at least one processor.

According to an embodiment, the second housing 220 may be at least partially coupled to a second side of the hinge module 240. The second housing 220 may be configured to be foldable and unfoldable with the first housing 210 around the hinge module 240. The second housing 220 may include the second printed circuit board 262. The second printed circuit board 262 may include the second board assembly 262 disclosed in FIG. 4. A portion of the second housing 220 may include a connector 207.

According to an embodiment, the second printed circuit board 262 may be disposed inside the second housing 220. The second printed circuit board 262 may include a third sensor 513 and/or a second tuner 522. For example, the third sensor 513 and the FPCB 280 may be electrically connected via a third connection path 503. For example, the second tuner 522 and the FPCB 280 may be electrically connected via a fourth connection path 504. For example, the second tuner 522, the FPCB 280, and the connector 207 may be electrically connected via a second signal path 532 and may transmit and/or receive a signal.

According to an embodiment, the third sensor 513 may be configured to detect the folding angle and/or the unfolding angle of the first housing 210 and the second housing 220. The third sensor 513 may be configured to transmit the detected folding angle and/or unfolding angle of the first housing 210 and the second housing 220 to the processor 120. For example, the third sensor 513 may include at least one of a motion sensor, a gear counter, an image sensor, and a Hall sensor. For example, when the first sensor 511 electrically connected to the first printed circuit board 261 is a motion sensor, the third sensor 513 may also be a motion sensor. When the first sensor 511 and the third sensor 513 are motion sensors, the folding angle and/or the unfolding angle may be calculated based on gravitational acceleration corresponding to the folded state and/or the unfolded state of the first housing 210 and the second housing 220. For example, when the first sensor 511 electrically connected to the first printed circuit board 261 is a Hall sensor, the third sensor 513 may be replaced with a magnet.

According to an embodiment, the second tuner 522 may be configured to compensate for (e.g., correct) an impedance of the FPCB 280 under control of the processor 120. The second tuner 522 may be configured to compensate for a change in impedance of the FPCB 280 caused by folding of the first housing 210 and the second housing 220. For example, the second tuner 522 may include at least one matching element (e.g., a capacitor and/or an inductor). The second tuner 522 may be configured to match an impedance difference of the FPCB 280 caused by folding of the first housing 210 and the second housing 220. The second tuner 522 may be disposed between the FPCB 280 and the connector 207. The second tuner 522 may be disposed adjacent to the FPCB 280 compared to the third sensor 513 and the connector 207.

According to various embodiments, a flexible display 230 (e.g., the flexible display 230 of FIG. 2A, FIG. 2B, FIG. 3B, and/or FIG. 4) may be disposed on the first housing 210, the hinge module 240, and the second housing 220 to be foldable and/or unfoldable.

According to an embodiment, the hinge module 240 may be disposed between the first housing 210 and the second housing 220 and may be configured to allow the first housing 210 and the second housing 220 to rotate. The hinge module 240 may be disposed such that the first housing 210 and the second housing 220 are foldable and/or unfoldable about a folding axis (e.g., the folding axis F of FIG. 2A, FIG. 2B, FIG. 2C, FIG. 3A, and/or FIG. 3B). The hinge module 240 may have a first side coupled to at least a portion of the first housing 210 and a second side coupled to at least a portion of the second housing 220.

According to an embodiment, the FPCB 280 may electrically connect the first printed circuit board 261 and the second printed circuit board 262. At least a portion of the FPCB 280 may be disposed in the hinge module 240. The FPCB 280 may be disposed across the first housing 210 and the second housing 220 through the hinge module 240. Depending on the folded and/or unfolded state of the first housing 210 and the second housing 220, at least a portion of the FPCB 280 corresponding to the hinge module 240 may be bent. The FPCB 280 may include the wiring member 280 disclosed in FIG. 4.

According to an embodiment, the connector 207 (e.g., a USB connector) may be disposed in the second housing 220. The connector 207 may be disposed in a portion of the second housing 220. The connector 207 may be electrically connected to the second printed circuit board 262 and the FPCB 280. The connector 207 may electrically connect the electronic device 200 to an external electronic device (e.g., a charging device). The electronic device 200 may be configured to transmit and receive a signal to and from an external electronic device (e.g., the external electronic devices 102 and 104 of FIG. 1) through the connector 207 (e.g., a USB connector). The connector 207 may include the interface 177 and the connection terminal 178 illustrated in FIG. 1 and/or the connector port 207 illustrated in FIGS. 2A and 3A.

FIG. 6 is a view schematically illustrating some components of an electronic device (e.g., a foldable electronic device) including the FPCB and a board-to-board (BTB) connector in the unfolded state, according to an embodiment of the disclosure.

According to various embodiments, the electronic device 200 (e.g., a foldable electronic device) illustrated in FIG. 6 may include at least some embodiments of the electronic devices 101 and 200 illustrated in FIGS. 1 to 5. In the following descriptions of various embodiments of the disclosure, components that are substantially the same as those illustrated in FIGS. 1 to 5 above may be assigned the same reference numerals, and redundant descriptions of their functions may be omitted.

Referring to FIG. 6, the electronic device 200 (e.g., a foldable electronic device) according to an embodiment of the disclosure may include a first housing 210, a second housing 220, a hinge module 240, an FPCB 280, a first connector 610, a second connector 620, and/or a connector 207.

According to an embodiment, the first housing 210 may be at least partially coupled to a first side of the hinge module 240. The first housing 210 may be configured to be foldable and unfoldable with the second housing 220 about the hinge module 240. The first housing 210 may include a first printed circuit board 261.

According to an embodiment, the first printed circuit board 261 may be disposed inside the first housing 210. The first printed circuit board 261 may include a first sensor 511, a second sensor 512, a first tuner 521, a memory 130, and/or a processor 120. The first printed circuit board 261 may be electrically connected to the FPCB 280 via the first connector 610.

According to an embodiment, the first sensor 511 may be configured to detect a folding angle and/or an unfolding angle between the first housing 210 and the second housing 220. The first sensor 511 may be configured to detect an angle (e.g., a rotation angle) corresponding to the folded state and/or the unfolded state of the first housing 210 and the second housing 220 with respect to the hinge module 240. The first sensor 511 may be configured to deliver the detected folding angle and/or unfolding angle of the first housing 210 and the second housing 220 to the processor 120.

According to an embodiment, the second sensor 512 may be configured to detect an impedance change (e.g., an amount of change) of the FPCB 280 based on the folding angle and/or the unfolding angle between the first housing 210 and the second housing 220. The second sensor 512 may be configured to deliver the detected impedance change of the FPCB 280 to the processor 120. For example, the second sensor 512 may include an impedance detection circuit configured to detect a change in impedance of the FPCB 280 based on the folding angle and/or the unfolding angle between the first housing 210 and the second housing 220.

According to an embodiment, the first tuner 521 may be configured to compensate for (e.g., correct) an impedance of the FPCB 280 under control of the processor 120. The first tuner 521 may be configured to compensate for a change in impedance of the FPCB 280 caused by folding of the first housing 210 and the second housing 220. For example, the first tuner 521 may include at least one matching element (e.g., a capacitor and/or an inductor). The first tuner 521 may be configured to match an impedance difference of the FPCB 280 caused by folding of the first housing 210 and the second housing 220.

According to an embodiment, the memory 130 may be configured to store a matching value capable of matching an impedance difference of the FPCB 280 caused by folding of the first housing 210 and the second housing 220 and/or a configured value for compensating so as to maintain signal quality. The memory 130 may be configured to store a configured value related to a matching value and/or a compensation value capable of matching a mismatch in impedance of the FPCB 280 based on the folding angle and/or the unfolding angle of the first housing 210 and the second housing 220. The memory 130 may be configured to store a table related to a matching value and/or a configured value for compensating for an impedance of the FPCB 280 based on the folding angle and/or the unfolding angle of the first housing 210 and the second housing 220.

According to an embodiment, the processor 120 may be operatively connected to the first sensor 511, the second sensor 512, the first tuner 521, and the memory 130, which are disposed on the first printed circuit board 261. The processor 120 may be operatively connected to the third sensor 513, the second tuner 522, and the connector 207 (e.g., a USB connector), which are disposed on the second printed circuit board 262. The processor 120 may be configured to control functions and operations of the first tuner 521 and/or the second tuner 522 based on at least one instruction stored in the memory 130. The processor 120 may be configured to control the first tuner 521 and/or the second tuner 522 based on the folding angle and/or the unfolding angle of the first housing 210 and the second housing 220, so as to compensate for a change in impedance of the FPCB 280.

According to an embodiment, the second housing 220 may be at least partially coupled to a second side of the hinge module 240. The second housing 220 may be configured to be foldable and unfoldable with the first housing 210 around the hinge module 240. The second housing 220 may include the second printed circuit board 262.

According to an embodiment, the second printed circuit board 262 may be disposed inside the second housing 220. The second printed circuit board 262 may include a third sensor 513 and/or a second tuner 522. The second printed circuit board 262 may be electrically connected to the FPCB 280 via the second connector 620.

According to an embodiment, the third sensor 513 may be configured to detect the folding angle and/or the unfolding angle of the first housing 210 and the second housing 220. The third sensor 513 may be configured to transmit the detected folding angle and/or unfolding angle of the first housing 210 and the second housing 220 to the processor 120.

According to an embodiment, the second tuner 522 may be configured to compensate for (e.g., correct) an impedance of the FPCB 280 under control of the processor 120. The second tuner 522 may be configured to compensate for a change in impedance of the FPCB 280 caused by folding of the first housing 210 and the second housing 220. For example, the second tuner 522 may include at least one matching element (e.g., a capacitor and/or an inductor). The second tuner 522 may be configured to match an impedance difference of the FPCB 280 caused by folding of the first housing 210 and the second housing 220.

According to an embodiment, the hinge module 240 may be disposed between the first housing 210 and the second housing 220 and may be configured to allow the first housing 210 and the second housing 220 to rotate. The hinge module 240 may be disposed such that the first housing 210 and the second housing 220 are foldable and/or unfoldable about a folding axis (e.g., the folding axis F of FIG. 2A, FIG. 2B, FIG. 2C, FIG. 3A, and/or FIG. 3B). The hinge module 240 may have a first side coupled to at least a portion of the first housing 210 and a second side coupled to at least a portion of the second housing 220.

According to an embodiment, the FPCB 280 may be electrically connected to the first printed circuit board 261 and the second printed circuit board 262 through the first connector 610 and the second connector 620. At least a portion of the FPCB 280 may be disposed in the hinge module 240. The FPCB 280 may be disposed across the first housing 210 and the second housing 220 through the hinge module 240. Depending on the folded and/or unfolded state of the first housing 210 and the second housing 220, at least a portion of the FPCB 280 may be bent at a portion corresponding to the hinge module 240.

According to an embodiment, the first connector 610 may be electrically connected to a first side of the FPCB 280. The first connector 610 may electrically connect the first side of the FPCB 280 and the first printed circuit board 261.

According to an embodiment, the second connector 620 may be electrically connected to a second side of the FPCB 280. The second connector 620 may electrically connect the second side of the FPCB 280 and the second printed circuit board 262.

According to various embodiments, the first connector 610 and the second connector 620 may form a board-to-board (BTB) connectors that electrically connect the first printed circuit board 261, the FPCB 280, and the second printed circuit board 262.

According to an embodiment, the connector 207 (e.g., a USB connector) may be disposed in the second housing 220. The connector 207 may be disposed in a portion of the second housing 220. The connector 207 may be electrically connected to the second printed circuit board 262 and the FPCB 280. The connector 207 may electrically connect the electronic device 200 to an external electronic device (e.g., a charging device). The electronic device 200 may be configured to transmit and receive a signal to and from an external electronic device (e.g., the external electronic devices 102 and 104 of FIG. 1) through the connector 207 (e.g., a USB connector).

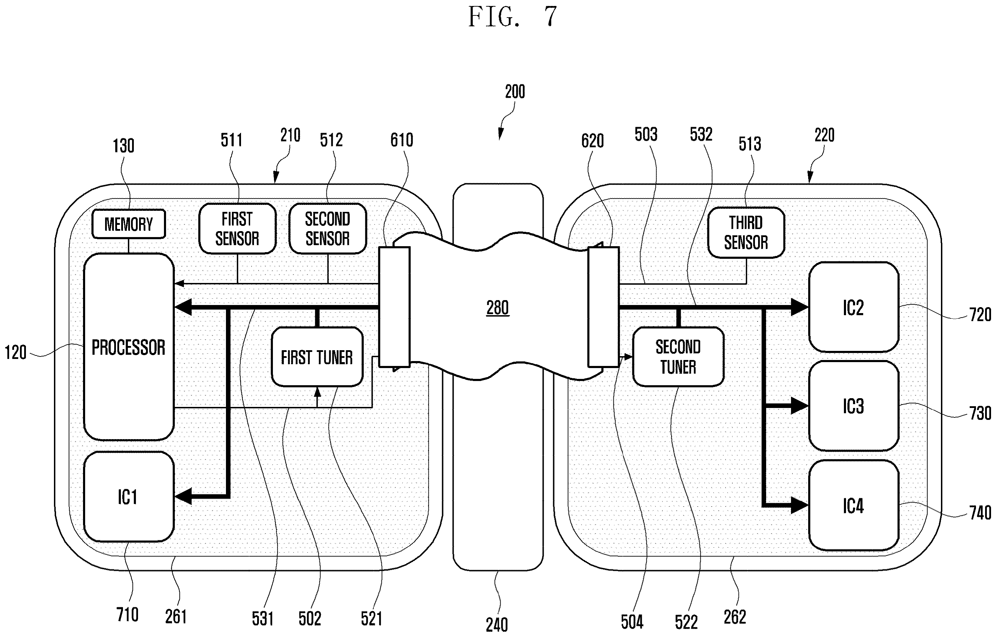

FIG. 7 is a view schematically illustrating some components of an electronic device (e.g., a foldable electronic device) including an FPCB and at least one integrated circuit (IC) in an unfolded state, according to an embodiment of the disclosure.

According to various embodiments, the electronic device 200 (e.g., a foldable electronic device) illustrated in FIG. 7 may include at least some embodiments of the electronic devices 101 and 200 illustrated in FIGS. 1 to 6. In the description of FIG. 7, the same reference numerals may be assigned to components substantially identical to those described above with reference to the embodiments of FIGS. 5 and 6, and redundant descriptions of their functions may be omitted.

Referring to FIG. 7, the electronic device 200 (e.g., a foldable electronic device) according to an embodiment of the disclosure may include a first housing 210, a second housing 220, a hinge module 240, an FPCB 280, a first IC 710, a second IC 720, a third IC 730, and/or a fourth IC 740.

According to an embodiment, the first housing 210 may be at least partially coupled to a first side of the hinge module 240. The first housing 210 may be configured to be foldable and unfoldable with the second housing 220 about the hinge module 240. The first housing 210 may include a first printed circuit board 261.

According to an embodiment, the first printed circuit board 261 may be disposed inside the first housing 210. The first printed circuit board 261 may include a first sensor 511, a second sensor 512, a first tuner 521, a first IC 710, a memory 130, and/or a processor 120. The first printed circuit board 261 may be electrically connected to the FPCB 280 via the first connector 610. For example, the first sensor 511, the second sensor 512, the processor 120, the first connector 610, and the FPCB 280 may be electrically connected via a first connection path 501. For example, the first tuner 521, the processor 120, the first connector 610, and the FPCB 280 may be electrically connected via a second connection path 502. For example, the first tuner 521, the processor 120, the first connector 610, the FPCB 280, and the first IC 710 may be electrically connected via a first signal path 531 and may transmit and/or receive signals.

According to an embodiment, the first sensor 511 may be configured to detect a folding angle and/or an unfolding angle between the first housing 210 and the second housing 220. The first sensor 511 may be configured to detect an angle (e.g., a rotation angle) corresponding to the folded state and/or the unfolded state of the first housing 210 and the second housing 220 with respect to the hinge module 240. The first sensor 511 may be configured to deliver the detected folding angle and/or unfolding angle of the first housing 210 and the second housing 220 to the processor 120.

According to an embodiment, the second sensor 512 may be configured to detect an impedance change (e.g., an amount of change) of the FPCB 280 based on the folding angle and/or the unfolding angle between the first housing 210 and the second housing 220. The second sensor 512 may be configured to deliver the detected impedance change of the FPCB 280 to the processor 120. For example, the second sensor 512 may include an impedance detection circuit configured to detect a change in impedance of the FPCB 280 based on the folding angle and/or the unfolding angle between the first housing 210 and the second housing 220.

According to an embodiment, the first tuner 521 may be configured to compensate for (e.g., correct) an impedance of the FPCB 280 under control of the processor 120. The first tuner 521 may be configured to compensate for a change in impedance of the FPCB 280 caused by folding of the first housing 210 and the second housing 220. For example, the first tuner 521 may include at least one matching element (e.g., a capacitor and/or an inductor). The first tuner 521 may be configured to match an impedance difference of the FPCB 280 caused by folding of the first housing 210 and the second housing 220.

According to an embodiment, the first IC 710 may be disposed between the first tuner 521 and the processor 120. For example, the first IC 710 may include at least one of a camera module and a communication processor. The first IC 710 may compensate for the impedance of the FPCB 280 through the first tuner 521 under the control of the processor 120, thereby ensuring the stability of transmission and reception signals and maintaining high-speed communication. According to various embodiments, the first IC 710 is not limited to the camera module or the communication processor, and may include various other ICs.

According to an embodiment, the memory 130 may be configured to store a matching value capable of matching an impedance difference of the FPCB 280 caused by folding of the first housing 210 and the second housing 220 and/or a configured value for compensating so as to maintain signal quality. The memory 130 may be configured to store a configured value related to a matching value and/or a compensation value capable of matching a mismatch in impedance of the FPCB 280 based on the folding angle and/or the unfolding angle of the first housing 210 and the second housing 220. The memory 130 may be configured to store a table related to a matching value and/or a configured value for compensating for an impedance of the FPCB 280 based on the folding angle and/or the unfolding angle of the first housing 210 and the second housing 220.

According to an embodiment, the processor 120 may be operatively connected to the first sensor 511, the second sensor 512, the first tuner 521, and the memory 130, which are disposed on the first printed circuit board 261. The processor 120 may be operatively connected to the third sensor 513, the second tuner 522, and the connector 207 (e.g., a USB connector), which are disposed on the second printed circuit board 262. The processor 120 may be configured to control functions and operations of the first tuner 521 and/or the second tuner 522 based on at least one instruction stored in the memory 130. The processor 120 may be configured to control the first tuner 521 and/or the second tuner 522 based on the folding angle and/or the unfolding angle of the first housing 210 and the second housing 220, so as to compensate for a change in impedance of the FPCB 280.

According to an embodiment, the second housing 220 may be at least partially coupled to a second side of the hinge module 240. The second housing 220 may be configured to be foldable and unfoldable with the first housing 210 around the hinge module 240. The second housing 220 may include the second printed circuit board 262.

According to an embodiment, the second printed circuit board 262 may be disposed inside the second housing 220. The second printed circuit board 262 may include a third sensor 513, a second tuner 522, a second IC 720, a third IC 730, and/or a fourth IC 740. The second printed circuit board 262 may be electrically connected to the FPCB 280 via the second connector 620. For example, the third sensor 513, the second connector 620, and the FPCB 280 may be electrically connected via a third connection path 503. For example, the second tuner 522, the second connector 620, and the FPCB 280 may be electrically connected via a fourth connection path 504. For example, the second tuner 522, the second IC 720, the third IC 730, the fourth IC 740, the second connector 620, and the FPCB 280 may be electrically connected via a second signal path 532 to transmit and/or receive a signal.

According to an embodiment, the third sensor 513 may be configured to detect the folding angle and/or the unfolding angle of the first housing 210 and the second housing 220. The third sensor 513 may be configured to transmit the detected folding angle and/or unfolding angle of the first housing 210 and the second housing 220 to the processor 120.

According to an embodiment, the second tuner 522 may be configured to compensate for (e.g., correct) an impedance of the FPCB 280 under control of the processor 120. The second tuner 522 may be configured to compensate for a change in impedance of the FPCB 280 caused by folding of the first housing 210 and the second housing 220. For example, the second tuner 522 may include at least one matching element (e.g., a capacitor and/or an inductor). The second tuner 522 may be configured to match an impedance difference of the FPCB 280 caused by folding of the first housing 210 and the second housing 220.

According to an embodiment, the second IC 720 may include at least one of a camera module and a communication processor. The third IC 730 may include at least one of a camera module and a communication processor. The fourth IC 740 may include at least one of a camera module and a communication processor. The second IC 720, the third IC 730, and/or the fourth IC 740 may compensate for the impedance of the FPCB 280 through the first tuner 521 and/or the second tuner 522 under the control of the processor 120, thereby ensuring the stability of transmission and reception signals and maintaining high-speed communication. According to various embodiments, the second IC 720, the third IC 730, and the fourth IC 740 may be omitted, or at least one of the second IC 720, the third IC 730, and the fourth IC 740 may be disposed. According to various embodiments, the second IC 720, the third IC 730, or the fourth IC 740 is not limited to the camera module and/or the communication processor and may include various other ICs.

According to an embodiment, the hinge module 240 may be disposed between the first housing 210 and the second housing 220 and may be configured to allow the first housing 210 and the second housing 220 to rotate. The hinge module 240 may be disposed such that the first housing 210 and the second housing 220 are foldable and/or unfoldable about a folding axis (e.g., the folding axis F of FIG. 2A, FIG. 2B, FIG. 2C, FIG. 3A, and/or FIG. 3B). The hinge module 240 may have a first side coupled to at least a portion of the first housing 210 and a second side coupled to at least a portion of the second housing 220.

According to an embodiment, the FPCB 280 may be electrically connected to the first printed circuit board 261 and the second printed circuit board 262 through the first connector 610 and the second connector 620. At least a portion of the FPCB 280 may be disposed in the hinge module 240. The FPCB 280 may be disposed across the first housing 210 and the second housing 220 through the hinge module 240. Depending on the folded and/or unfolded state of the first housing 210 and the second housing 220, at least a portion of the FPCB 280 may be bent at a portion corresponding to the hinge module 240.

According to an embodiment, the first connector 610 may be electrically connected to a first side of the FPCB 280. The first connector 610 may electrically connect the first side of the FPCB 280 and the first printed circuit board 261.

According to an embodiment, the second connector 620 may be electrically connected to a second side of the FPCB 280. The second connector 620 may electrically connect the second side of the FPCB 280 and the second printed circuit board 262.

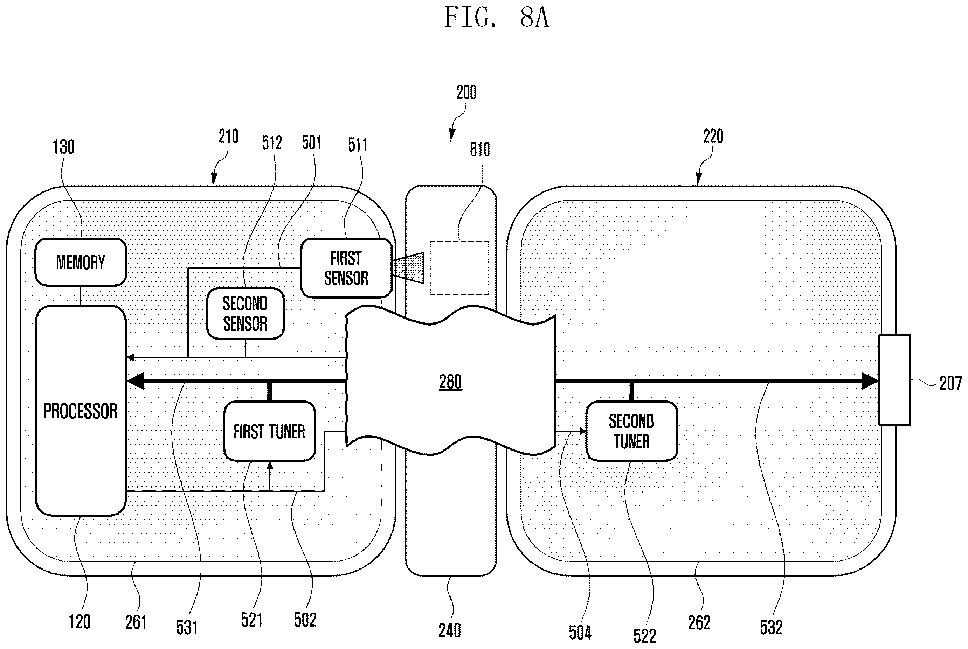

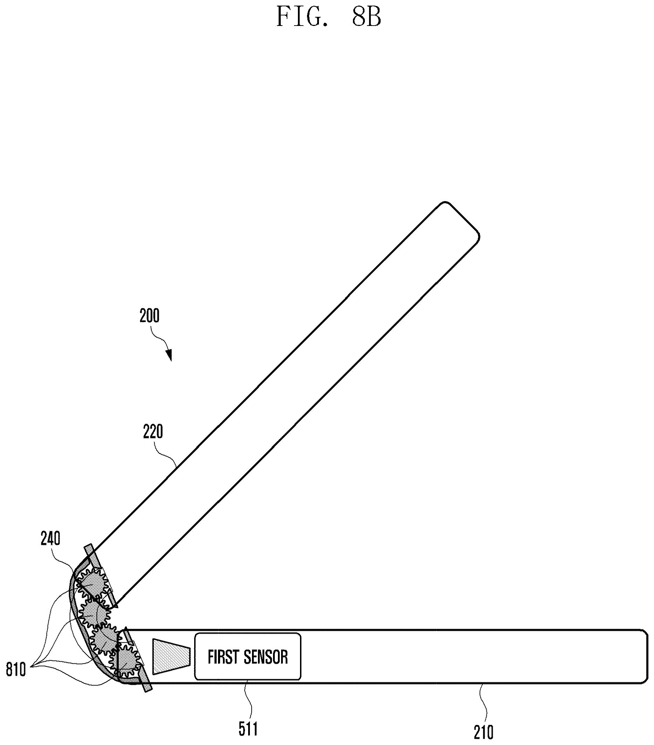

FIG. 8A is a view schematically illustrating some components in which a first sensor of an electronic device (e.g., a foldable electronic device) according to an embodiment of the disclosure is a gear counter. FIG. 8B is a view illustrating an example in which the first sensor (e.g., a gear counter) according to an embodiment of the disclosure is disposed in a first housing.

According to various embodiments, the electronic device 200 (e.g., a foldable electronic device) illustrated in FIGS. 8A and 8B may include at least some embodiments of the electronic devices 101 and 200 illustrated in FIGS. 1 to 7. In the description of FIGS. 8A and 8B, the same reference numerals may be assigned to components substantially identical to those described above with reference to the embodiments of FIGS. 5 to 7, and redundant descriptions of their functions may be omitted.

Referring to FIGS. 8A and 8B, an electronic device 200 (e.g., a foldable electronic device) according to an embodiment of the disclosure may include a first housing 210, a second housing 220, a hinge module 240, an FPCB 280, and/or a connector 207.

According to an embodiment, the first housing 210 may be at least partially coupled to a first side of the hinge module 240. The first housing 210 may be configured to be foldable and unfoldable with the second housing 220 about the hinge module 240. The first housing 210 may include a first printed circuit board 261.

According to an embodiment, the first printed circuit board 261 may be disposed inside the first housing 210. The first printed circuit board 261 may include a first sensor 511, a second sensor 512, a first tuner 521, a memory 130, and/or a processor 120. For example, the first sensor 511, the second sensor 512, the processor 120, and the FPCB 280 may be electrically connected via a first connection path 501. For example, the first tuner 521, the processor 120, and the FPCB 280 may be electrically connected via a second connection path 502. For example, the first tuner 521, the processor 120, and the FPCB 280 may be electrically connected via a first signal path 531 and may transmit and/or receive a signal.

According to an embodiment, the first sensor 511 (e.g., a gear counter) may be configured to count the number of rotations of at least one gear 810 disposed in the hinge module 240. The first sensor 511 (e.g., a gear counter) may be configured to transmit the counted number of rotations of the at least one gear 810 to the processor 120. The processor 120 may be configured to detect and/or calculate a folding angle and/or an unfolding angle of the first housing 210 and the second housing 220 based on the number of rotations of the at least one gear 810 disposed in the hinge module 240. For example, when the first sensor 511 is a gear counter configured to count the number of rotations of the at least one gear 810 disposed in the hinge module 240, the second printed circuit board 220 may not include the third sensor (e.g., the third sensor 513 of FIG. 5).

According to an embodiment, the second sensor 512 may be configured to detect a change (e.g., an amount of change) in impedance of the FPCB 280 based on the number of rotations of the at least one gear 810 disposed in the hinge module 240 and/or the folding angle and/or the unfolding angle of the first housing 210 and the second housing 220. The second sensor 512 may be configured to deliver the detected impedance change of the FPCB 280 to the processor 120. For example, the second sensor 512 may include an impedance detection circuit configured to detect a change in impedance of the FPCB 280 based on the number of rotations of the at least one gear 810 disposed in the hinge module 240 and/or the folding angle and/or the unfolding angle of the first housing 210 and the second housing 220.

According to an embodiment, the first tuner 521 may be configured to compensate for (e.g., correct) an impedance of the FPCB 280 under control of the processor 120. The first tuner 521 may be configured to compensate for a change in impedance of the FPCB 280 caused by folding of the first housing 210 and the second housing 220. For example, the first tuner 521 may include at least one matching element (e.g., a capacitor and/or an inductor). The first tuner 521 may be configured to match an impedance difference of the FPCB 280 caused by folding of the first housing 210 and the second housing 220.

According to an embodiment, the memory 130 may be configured to store a matching value capable of matching an impedance difference of the FPCB 280 caused by folding of the first housing 210 and the second housing 220 and/or a configured value for compensating so as to maintain signal quality. The memory 130 may be configured to store a configured value related to a matching value and/or a compensation value capable of matching a mismatch in impedance of the FPCB 280 based on the folding angle and/or the unfolding angle of the first housing 210 and the second housing 220. The memory 130 may be configured to store a table related to a matching value and/or a configured value for compensating for an impedance of the FPCB 280 based on the folding angle and/or the unfolding angle of the first housing 210 and the second housing 220.

According to an embodiment, the processor 120 may be operatively connected to the first sensor 511, the second sensor 512, the first tuner 521, and the memory 130, which are disposed on the first printed circuit board 261. The processor 120 may be operatively connected to the second tuner 522, and the connector 207 (e.g., a USB connector), which are disposed on the second printed circuit board 262. The processor 120 may be configured to control functions and operations of the first tuner 521 and/or the second tuner 522 based on at least one instruction stored in the memory 130. The processor 120 may be configured to control the first tuner 521 and/or the second tuner 522 based on the folding angle and/or the unfolding angle of the first housing 210 and the second housing 220, so as to compensate for a change in impedance of the FPCB 280.

According to an embodiment, the second housing 220 may be at least partially coupled to a second side of the hinge module 240. The second housing 220 may be configured to be foldable and unfoldable with the first housing 210 around the hinge module 240. The second housing 220 may include the second printed circuit board 262. A portion of the second housing 220 may include a connector 207.

According to an embodiment, the second printed circuit board 262 may be disposed inside the second housing 220. The second printed circuit board 262 may include the second tuner 522. The second tuner 522 and the FPCB 280 may be electrically connected via the fourth connection path 504. For example, the second tuner 522, the FPCB 280, and the connector 207 may be electrically connected via a second signal path 532 and may transmit and/or receive a signal.

According to an embodiment, the second tuner 522 may be configured to compensate for (e.g., correct) an impedance of the FPCB 280 under control of the processor 120. The second tuner 522 may be configured to compensate for a change in impedance of the FPCB 280 caused by folding of the first housing 210 and the second housing 220. For example, the second tuner 522 may include at least one matching element (e.g., a capacitor and/or an inductor). The second tuner 522 may be configured to match an impedance difference of the FPCB 280 caused by folding of the first housing 210 and the second housing 220.

According to an embodiment, the hinge module 240 may include at least one gear 810. The hinge module 240 may be disposed between the first housing 210 and the second housing 220, and may be configured to allow the first housing 210 and the second housing 220 to rotate via the at least one gear 810. The hinge module 240 may have a first side coupled to at least a portion of the first housing 210 and a second side coupled to at least a portion of the second housing 220.

According to an embodiment, the FPCB 280 may electrically connect the first printed circuit board 261 and the second printed circuit board 262. At least a portion of the FPCB 280 may be disposed in the hinge module 240. The FPCB 280 may be disposed across the first housing 210 and the second housing 220 through the hinge module 240. Depending on the folded and/or unfolded state of the first housing 210 and the second housing 220, at least a portion of the FPCB 280 may be bent at a portion corresponding to the hinge module 240.

According to an embodiment, the connector 207 (e.g., a USB connector) may be disposed in the second housing 220. The connector 207 may be disposed in a portion of the second housing 220. The connector 207 may be electrically connected to the second printed circuit board 262 and the FPCB 280. The connector 207 may electrically connect the electronic device 200 to an external electronic device (e.g., a charging device). The electronic device 200 may be configured to transmit and receive a signal to and from an external electronic device (e.g., the external electronic devices 102 and 104 of FIG. 1) through the connector 207 (e.g., a USB connector).

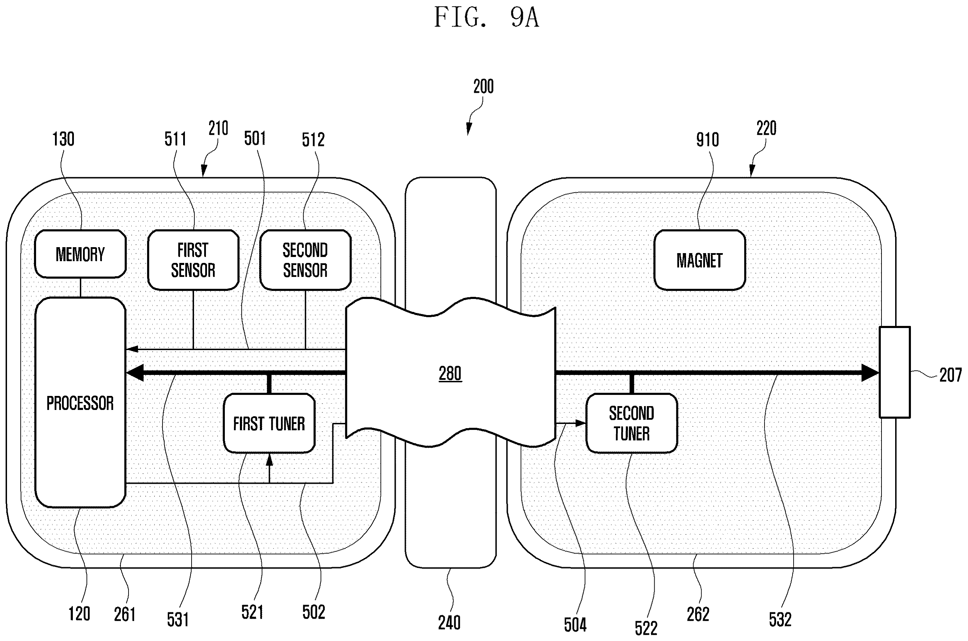

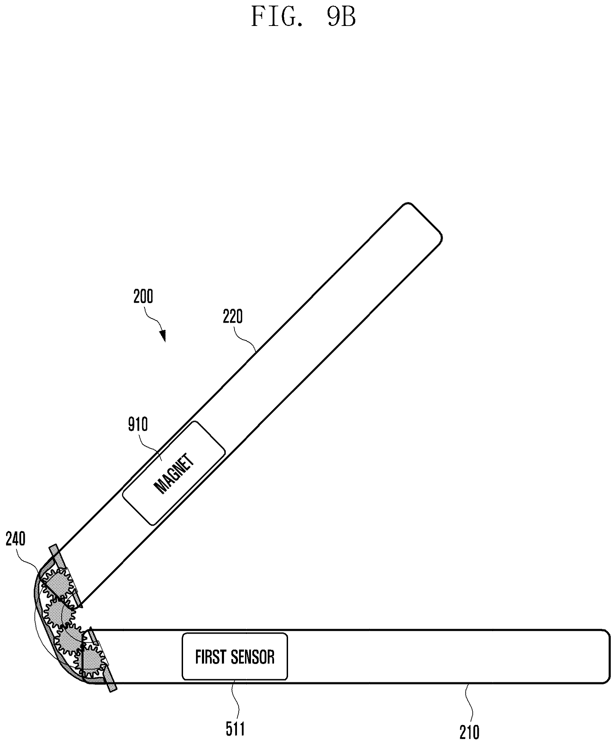

FIG. 9A is a view schematically illustrating some components in which a first sensor disposed in a first housing of an electronic device (e.g., a foldable electronic device) according to an embodiment of the disclosure is a Hall sensor, and a magnet is disposed in a second housing. FIG. 9B is a view illustrating an example in which the first sensor (e.g., a Hall sensor) according to an embodiment of the disclosure is disposed in the first housing and the magnet is disposed in the second housing.

According to various embodiments, the electronic device 200 (e.g., a foldable electronic device) illustrated in FIGS. 9A and 9B may include at least some embodiments of the electronic devices 101 and 200 illustrated in FIGS. 1 to 8B. In the description of FIGS. 9A and 9B, the same reference numerals may be assigned to components substantially identical to those described above with reference to the embodiments of FIGS. 5 to 8B, and redundant descriptions of their functions may be omitted.

Referring to FIGS. 9A and 9B, an electronic device 200 (e.g., a foldable electronic device) according to an embodiment of the disclosure may include a first housing 210, a second housing 220, a hinge module 240, an FPCB 280, and/or a connector 207.

According to an embodiment, the first housing 210 may be at least partially coupled to a first side of the hinge module 240. The first housing 210 may be configured to be foldable and unfoldable with the second housing 220 about the hinge module 240. The first housing 210 may include a first printed circuit board 261.

According to an embodiment, the first printed circuit board 261 may be disposed inside the first housing 210. The first printed circuit board 261 may include a first sensor 511, a second sensor 512, a first tuner 521, a memory 130, and/or a processor 120. For example, the first sensor 511, the second sensor 512, the processor 120, and the FPCB 280 may be electrically connected via a first connection path 501. For example, the first tuner 521, the processor 120, and the FPCB 280 may be electrically connected via a second connection path 502. For example, the first tuner 521, the processor 120, and the FPCB 280 may be electrically connected via a first signal path 531 and may transmit and/or receive a signal.

According to an embodiment, the first sensor 511 (e.g., a Hall sensor) may be configured to sense the magnetic force of the magnet 910 disposed in the second housing 220 and to detect a folding angle and/or an unfolding angle of the first housing 210 and the second housing 220. The first sensor 511 (e.g., a Hall sensor) may be configured to detect, together with the magnet 910, an angle (e.g., a rotation angle) corresponding to a folded state and/or an unfolded state of the first housing 210 and the second housing 220 with respect to the hinge module 240. The first sensor 511 may be configured to sense the magnetic force of the magnet 910 disposed on the second housing 220 and to transmit the sensed magnetic information to the processor 120. The processor 120 may be configured to detect and/or calculate a folding angle and/or an unfolding angle of the first housing 210 and the second housing 220 based on the magnetic information sensed by the first sensor 511 and the magnet 910.

According to an embodiment, the second sensor 512 may be configured to detect an impedance change (e.g., an amount of change) of the FPCB 280 based on the folding angle and/or the unfolding angle between the first housing 210 and the second housing 220. The second sensor 512 may be configured to deliver the detected impedance change of the FPCB 280 to the processor 120. For example, the second sensor 512 may include an impedance detection circuit configured to detect a change in impedance of the FPCB 280 based on the folding angle and/or the unfolding angle between the first housing 210 and the second housing 220.

According to an embodiment, the first tuner 521 may be configured to compensate for (e.g., correct) an impedance of the FPCB 280 under control of the processor 120. The first tuner 521 may be configured to compensate for a change in impedance of the FPCB 280 caused by folding of the first housing 210 and the second housing 220. For example, the first tuner 521 may include at least one matching element (e.g., a capacitor and/or an inductor). The first tuner 521 may be configured to match an impedance difference of the FPCB 280 caused by folding of the first housing 210 and the second housing 220.

According to an embodiment, the memory 130 may be configured to store a matching value capable of matching an impedance difference of the FPCB 280 caused by folding of the first housing 210 and the second housing 220 and/or a configured value for compensating so as to maintain signal quality. The memory 130 may be configured to store a configured value related to a matching value and/or a compensation value capable of matching a mismatch in impedance of the FPCB 280 based on the folding angle and/or the unfolding angle of the first housing 210 and the second housing 220. The memory 130 may be configured to store a table related to a matching value and/or a configured value for compensating for an impedance of the FPCB 280 based on the folding angle and/or the unfolding angle of the first housing 210 and the second housing 220.

According to an embodiment, the processor 120 may be operatively connected to the first sensor 511, the second sensor 512, the first tuner 521, and the memory 130, which are disposed on the first printed circuit board 261. The processor 120 may be operatively connected to the second tuner 522, and the connector 207 (e.g., a USB connector), which are disposed on the second printed circuit board 262. The processor 120 may be configured to control functions and operations of the first tuner 521 and/or the second tuner 522 based on at least one instruction stored in the memory 130. The processor 120 may be configured to control the first tuner 521 and/or the second tuner 522 based on the folding angle and/or the unfolding angle of the first housing 210 and the second housing 220, so as to compensate for a change in impedance of the FPCB 280.

According to an embodiment, the second housing 220 may be at least partially coupled to a second side of the hinge module 240. The second housing 220 may be configured to be foldable and unfoldable with the first housing 210 around the hinge module 240. The second housing 220 may include the second printed circuit board 262. A portion of the second housing 220 may include a connector 207. The second housing 220 may include a magnet 910. The magnetic force of the magnet 910 may be sensed and detected through the first sensor 511 (e.g., a Hall sensor) electrically connected to a first circuit board 210 of the first housing 210.

According to an embodiment, the second printed circuit board 262 may be disposed inside the second housing 220. The second printed circuit board 262 may include the second tuner 522. The second tuner 522 and the FPCB 280 may be electrically connected via the fourth connection path 504. For example, the second tuner 522, the FPCB 280, and the connector 207 may be electrically connected via a second signal path 532 and may transmit and/or receive a signal.

According to an embodiment, the second tuner 522 may be configured to compensate for (e.g., correct) an impedance of the FPCB 280 under control of the processor 120. The second tuner 522 may be configured to compensate for a change in impedance of the FPCB 280 caused by folding of the first housing 210 and the second housing 220. For example, the second tuner 522 may include at least one matching element (e.g., a capacitor and/or an inductor). The second tuner 522 may be configured to match an impedance difference of the FPCB 280 caused by folding of the first housing 210 and the second housing 220.

According to an embodiment, the hinge module 240 may be disposed between the first housing 210 and the second housing 220 and may be configured to allow the first housing 210 and the second housing 220 to rotate. The hinge module 240 may be disposed such that the first housing 210 and the second housing 220 are foldable and/or unfoldable about a folding axis (e.g., the folding axis F of FIG. 2A, FIG. 2B, FIG. 2C, FIG. 3A, and/or FIG. 3B). The hinge module 240 may have a first side coupled to at least a portion of the first housing 210 and a second side coupled to at least a portion of the second housing 220.

According to an embodiment, the FPCB 280 may electrically connect the first printed circuit board 261 and the second printed circuit board 262. At least a portion of the FPCB 280 may be disposed in the hinge module 240. The FPCB 280 may be disposed across the first housing 210 and the second housing 220 through the hinge module 240. Depending on the folded and/or unfolded state of the first housing 210 and the second housing 220, at least a portion of the FPCB 280 may be bent at a portion corresponding to the hinge module 240.

According to an embodiment, the connector 207 (e.g., a USB connector) may be disposed in the second housing 220. The connector 207 may be disposed in a portion of the second housing 220. The connector 207 may be electrically connected to the second printed circuit board 262 and the FPCB 280. The connector 207 may electrically connect the electronic device 200 to an external electronic device (e.g., a charging device). The electronic device 200 may be configured to transmit and receive a signal to and from an external electronic device (e.g., the external electronic devices 102 and 104 of FIG. 1) through the connector 207 (e.g., a USB connector).

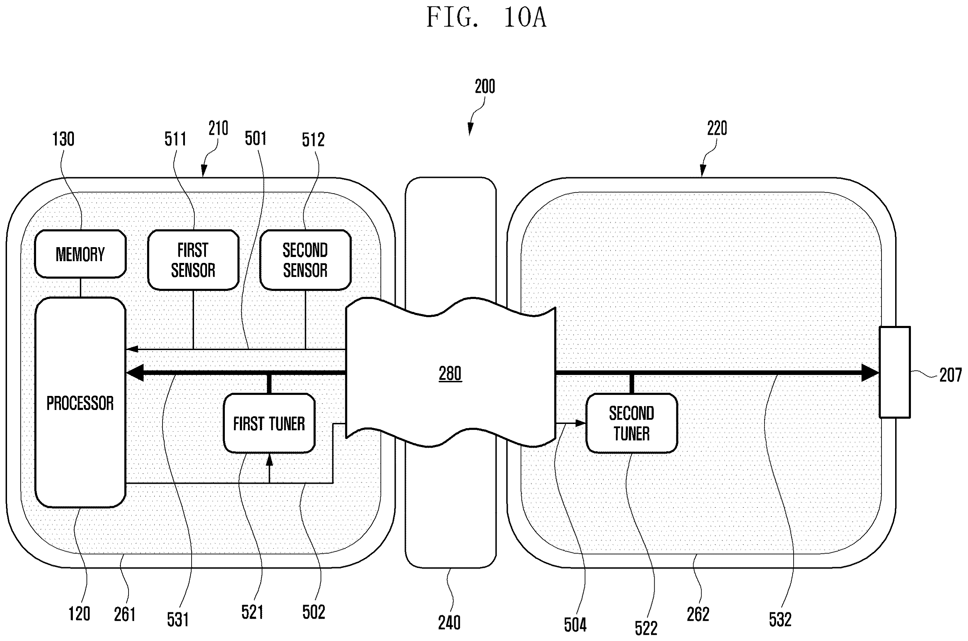

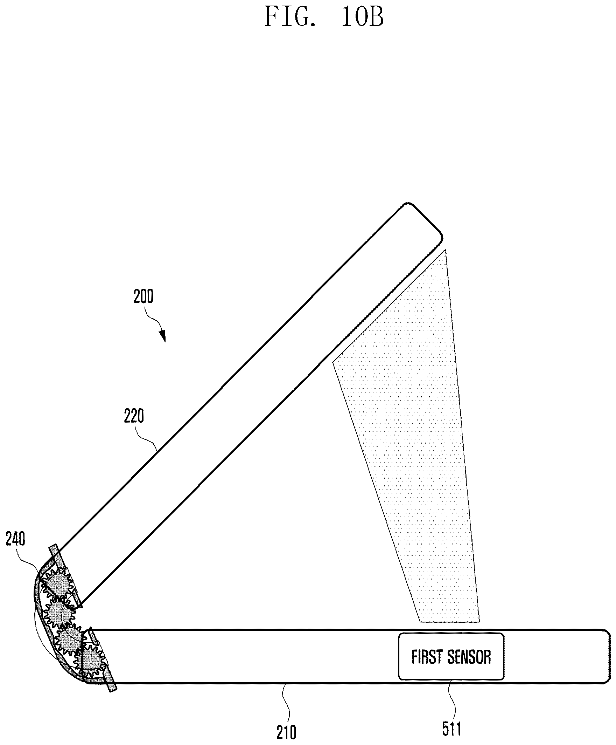

FIG. 10A is a view schematically illustrating some components in which a first sensor is an image sensor in an electronic device (e.g., a foldable electronic device) according to an embodiment of the disclosure. FIG. 10B is a view illustrating an example in which the first sensor (e.g., an image sensor) is disposed in the first housing according to an embodiment of the disclosure.

According to various embodiments, the electronic device 200 (e.g., a foldable electronic device) illustrated in FIGS. 10A and 10B may include at least some embodiments of the electronic devices 101 and 200 illustrated in FIGS. 1 to 9B. In the description of FIGS. 10A and 10B, the same reference numerals may be given to components substantially identical to those described above with reference to the embodiments of FIGS. 5 to 9B, and redundant descriptions of their functions may be omitted.

Referring to FIGS. 10A and 10B, an electronic device 200 (e.g., a foldable electronic device) according to an embodiment of the disclosure may include a first housing 210, a second housing 220, a hinge module 240, an FPCB 280, and/or a connector 207.

According to an embodiment, the first housing 210 may be at least partially coupled to a first side of the hinge module 240. The first housing 210 may be configured to be foldable and unfoldable with the second housing 220 about the hinge module 240. The first housing 210 may include a first printed circuit board 261.

According to an embodiment, the first printed circuit board 261 may be disposed inside the first housing 210. The first printed circuit board 261 may include a first sensor 511, a second sensor 512, a first tuner 521, a memory 130, and/or a processor 120. For example, the first sensor 511, the second sensor 512, the processor 120, and the FPCB 280 may be electrically connected via a first connection path 501. For example, the first tuner 521, the processor 120, and the FPCB 280 may be electrically connected via a second connection path 502. For example, the first tuner 521, the processor 120, and the FPCB 280 may be electrically connected via a first signal path 531 and may transmit and/or receive a signal.

According to an embodiment, the first sensor 511 (e.g., an image sensor) may be configured to sense an image corresponding to a folded state and/or an unfolded state of the second housing 220. The first sensor 511 (e.g., an image sensor) may be configured to transmit the sensed image information to the processor 120. The processor 120 may be configured to detect and/or calculate a folding angle and/or an unfolding angle of the first housing 210 and the second housing 220 based on the image information corresponding to the folded state and/or the unfolded state of the second housing 220 acquired through the first sensor 511 (e.g., an image sensor). According to various embodiments, the first sensor 511 (e.g., an image sensor) may be disposed on at least one of the first circuit board 261 and the second circuit board 262.

According to an embodiment, the second sensor 512 may be configured to detect an impedance change (e.g., an amount of change) of the FPCB 280 based on a folding angle and/or an unfolding angle of the first housing 210 and the second housing 220. The second sensor 512 may be configured to deliver the detected impedance change of the FPCB 280 to the processor 120. For example, the second sensor 512 may include an impedance detection circuit configured to detect a change in impedance of the FPCB 280 based on the folding angle and/or the unfolding angle between the first housing 210 and the second housing 220.

According to an embodiment, the first tuner 521 may be configured to compensate for (e.g., correct) an impedance of the FPCB 280 under control of the processor 120. The first tuner 521 may be configured to compensate for a change in impedance of the FPCB 280 caused by folding of the first housing 210 and the second housing 220. For example, the first tuner 521 may include at least one matching element (e.g., a capacitor and/or an inductor). The first tuner 521 may be configured to match an impedance difference of the FPCB 280 caused by folding of the first housing 210 and the second housing 220.

According to an embodiment, the memory 130 may be configured to store a matching value capable of matching an impedance difference of the FPCB 280 caused by folding of the first housing 210 and the second housing 220 and/or a configured value for compensating so as to maintain signal quality. The memory 130 may be configured to store a configured value related to a matching value and/or a compensation value capable of matching a mismatch in impedance of the FPCB 280 based on the folding angle and/or the unfolding angle of the first housing 210 and the second housing 220. The memory 130 may be configured to store a table related to a matching value and/or a configured value for compensating for an impedance of the FPCB 280 based on the folding angle and/or the unfolding angle of the first housing 210 and the second housing 220.

According to an embodiment, the processor 120 may be operatively connected to the first sensor 511, the second sensor 512, the first tuner 521, and the memory 130, which are disposed on the first printed circuit board 261. The processor 120 may be operatively connected to the second tuner 522, and the connector 207 (e.g., a USB connector), which are disposed on the second printed circuit board 262. The processor 120 may be configured to control functions and operations of the first tuner 521 and/or the second tuner 522 based on at least one instruction stored in the memory 130. The processor 120 may be configured to control the first tuner 521 and/or the second tuner 522 based on the folding angle and/or the unfolding angle of the first housing 210 and the second housing 220, so as to compensate for a change in impedance of the FPCB 280.

According to an embodiment, the second housing 220 may be at least partially coupled to a second side of the hinge module 240. The second housing 220 may be configured to be foldable and unfoldable with the first housing 210 around the hinge module 240. The second housing 220 may include the second printed circuit board 262. A portion of the second housing 220 may include a connector 207.

According to an embodiment, the second printed circuit board 262 may be disposed inside the second housing 220. The second printed circuit board 262 may include the second tuner 522. The second tuner 522 and the FPCB 280 may be electrically connected via the fourth connection path 504. For example, the second tuner 522, the FPCB 280, and the connector 207 may be electrically connected via a second signal path 532 and may transmit and/or receive a signal.

According to an embodiment, the second tuner 522 may be configured to compensate for (e.g., correct) an impedance of the FPCB 280 under control of the processor 120. The second tuner 522 may be configured to compensate for a change in impedance of the FPCB 280 caused by folding of the first housing 210 and the second housing 220. For example, the second tuner 522 may include at least one matching element (e.g., a capacitor and/or an inductor). The second tuner 522 may be configured to match an impedance difference of the FPCB 280 caused by folding of the first housing 210 and the second housing 220.

According to an embodiment, the hinge module 240 may be disposed between the first housing 210 and the second housing 220 and may be configured to allow the first housing 210 and the second housing 220 to rotate. The hinge module 240 may have a first side coupled to at least a portion of the first housing 210 and a second side coupled to at least a portion of the second housing 220.

According to an embodiment, the FPCB 280 may electrically connect the first printed circuit board 261 and the second printed circuit board 262. At least a portion of the FPCB 280 may be disposed in the hinge module 240. The FPCB 280 may be disposed across the first housing 210 and the second housing 220 through the hinge module 240. Depending on the folded and/or unfolded state of the first housing 210 and the second housing 220, at least a portion of the FPCB 280 may be bent at a portion corresponding to the hinge module 240.

According to an embodiment, the connector 207 (e.g., a USB connector) may be disposed in the second housing 220. The connector 207 may be disposed in a portion of the second housing 220. The connector 207 may be electrically connected to the second printed circuit board 262 and the FPCB 280. The connector 207 may electrically connect the electronic device 200 to an external electronic device (e.g., a charging device). The electronic device 200 may be configured to transmit and receive a signal to and from an external electronic device (e.g., the external electronic devices 102 and 104 of FIG. 1) through the connector 207 (e.g., a USB connector).

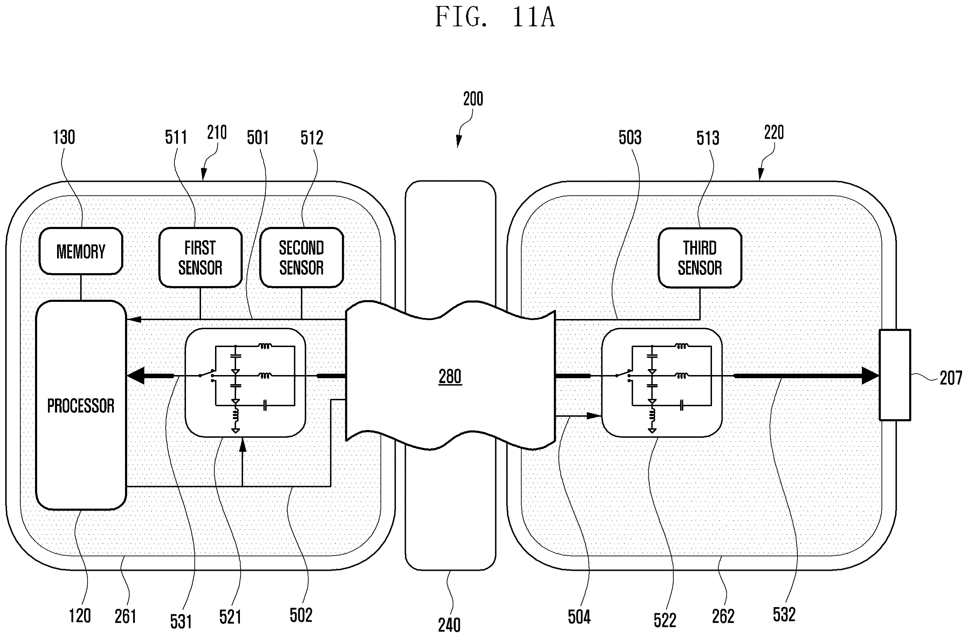

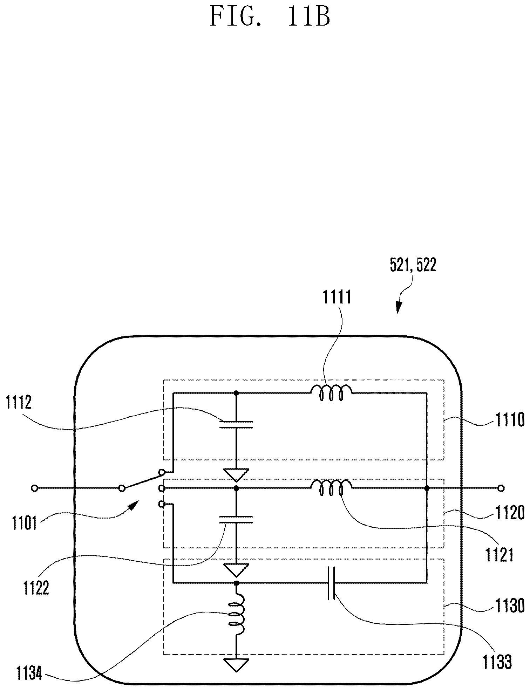

FIG. 11A is a view schematically illustrating some components of an electronic device (e.g., a foldable electronic device) including a first tuner and/or a second tuner according to an embodiment of the disclosure. FIG. 11B is an enlarged view schematically illustrating the configurations of the first tuner and the second tuner illustrated in FIG. 11A according to an embodiment of the disclosure.

According to various embodiments, the electronic device 200 (e.g., a foldable electronic device) illustrated in FIGS. 11A and 11B may include at least some embodiments of the electronic devices 101 and 200 illustrated in FIGS. 1 to 10B. In the description of FIGS. 11A and 11B, the same reference numerals may be given to components substantially identical to those described above with reference to the embodiments of FIGS. 5 to 10B, and redundant descriptions of their functions may be omitted.

Referring to FIGS. 11A and 11B, an electronic device 200 (e.g., a foldable electronic device) according to an embodiment of the disclosure may include a first housing 210, a second housing 220, a hinge module 240, an FPCB 280, and/or a connector 207.

According to an embodiment, the first housing 210 may be at least partially coupled to a first side of the hinge module 240. The first housing 210 may be configured to be foldable and unfoldable with the second housing 220 about the hinge module 240. The first housing 210 may include a first printed circuit board 261.

According to an embodiment, the first printed circuit board 261 may be disposed inside the first housing 210. The first printed circuit board 261 may include a first sensor 511, a second sensor 512, a first tuner 521, a memory 130, and/or a processor 120. For example, the first sensor 511, the second sensor 512, the processor 120, and the FPCB 280 may be electrically connected via a first connection path 501. For example, the first tuner 521, the processor 120, and the FPCB 280 may be electrically connected via a second connection path 502. For example, the first tuner 521, the processor 120, and the FPCB 280 may be electrically connected via a first signal path 531 and may transmit and/or receive a signal.

According to an embodiment, the first sensor 511 may be configured to detect a folding angle and/or an unfolding angle between the first housing 210 and the second housing 220. The first sensor 511 may be configured to detect an angle (e.g., a rotation angle) corresponding to the folded state and/or the unfolded state of the first housing 210 and the second housing 220 with respect to the hinge module 240. The first sensor 511 may be configured to deliver the detected folding angle and/or unfolding angle of the first housing 210 and the second housing 220 to the processor 120.

According to an embodiment, the second sensor 512 may be configured to detect an impedance change (e.g., an amount of change) of the FPCB 280 based on the folding angle and/or the unfolding angle between the first housing 210 and the second housing 220. The second sensor 512 may be configured to deliver the detected impedance change of the FPCB 280 to the processor 120. For example, the second sensor 512 may include an impedance detection circuit configured to detect a change in impedance of the FPCB 280 based on the folding angle and/or the unfolding angle between the first housing 210 and the second housing 220.

According to an embodiment, the first tuner 521 may be configured to compensate for (e.g., correct) an impedance of the FPCB 280 under control of the processor 120. The first tuner 521 may be configured to compensate for a change in impedance of the FPCB 280 caused by folding of the first housing 210 and the second housing 220. For example, the first tuner 521 may include at least one matching element (e.g., a capacitor and/or an inductor). The first tuner 521 may be configured to match an impedance difference of the FPCB 280 caused by folding of the first housing 210 and the second housing 220.

Referring to FIG. 11B, the first tuner 521 may include a switch 1101, a first matching circuit 1110, a second matching circuit 1120, and/or a third matching circuit 1130. The switch 1101 may electrically connect or disconnect the processor 120 and one of the first matching circuit 1110, the second matching circuit 1120, and the third matching circuit 1130. The first matching circuit 1110 may include a first inductor 1111 and a first capacitor 1112. The second matching circuit 1120 may include a second inductor 1121 and a second capacitor 1122. The third matching circuit 1130 may include a third capacitor 1133 and a third inductor 1134. For example, the matching values of the first matching circuit 1110, the second matching circuit 1120, and the third matching circuit 1130 may differ from each other. For example, the first matching circuit 1110 may have a first matching value. The second matching circuit 1120 may have a second matching value. The third matching circuit 1130 may have a third matching value. The processor 120 may be configured to control the first tuner 521 to apply a matching value (e.g., one of the first matching value, the second matching value, and the third matching value) corresponding to a change in impedance of the FPCB 280 to the FPCB 280.

According to various embodiments, the first matching circuit 1110, the second matching circuit 1120, or the third matching circuit 1130 of the first tuner 521 may be electrically connected to or disconnected from the processor 120 via the switch 1101. The switch 1101 may be electrically connected to one of the first matching circuit 1110, the second matching circuit 1120, and the third matching circuit 1130, which has a predetermined matching value, under the control of the processor 120. According to an embodiment, the switch 1101 may include one of a micro-electro mechanical system (MEMS) switch, a single pole single throw (SPST) switch, and a single pole double throw (SPDT) switch.

According to an embodiment, the memory 130 may be configured to store matching values (e.g., the first to third matching values) that compensate for impedance differences of the FPCB 280 generated caused by folding of the first housing 210 and the second housing 220 and/or a configured value for compensating so as to maintaining signal quality. The memory 130 may be configured to store a configured value related to a matching value and/or a compensation value capable of matching a mismatch in impedance of the FPCB 280 based on the folding angle and/or the unfolding angle of the first housing 210 and the second housing 220. The memory 130 may be configured to store a table related to a matching value and/or a configured value for compensating for an impedance of the FPCB 280 based on the folding angle and/or the unfolding angle of the first housing 210 and the second housing 220.

According to an embodiment, the processor 120 may be operatively connected to the first sensor 511, the second sensor 512, the first tuner 521, and the memory 130, which are disposed on the first printed circuit board 261. The processor 120 may be operatively connected to the third sensor 513, the second tuner 522, and the connector 207 (e.g., a USB connector), which are disposed on the second printed circuit board 262. The processor 120 may be configured to control functions and operations of the first tuner 521 and/or the second tuner 522 based on at least one instruction stored in the memory 130. The processor 120 may be configured to control a matching value of the first tuner 521 and/or a matching value of the second tuner 522 based on the folding angle and/or the unfolding angle of the first housing 210 and the second housing 220, so as to compensate for a change in impedance of the FPCB 280.

According to an embodiment, the second housing 220 may be at least partially coupled to a second side of the hinge module 240. The second housing 220 may be configured to be foldable and unfoldable with the first housing 210 around the hinge module 240. The second housing 220 may include the second printed circuit board 262. A portion of the second housing 220 may include a connector 207.

According to an embodiment, the second printed circuit board 262 may be disposed inside the second housing 220. The second printed circuit board 262 may include a third sensor 513 and/or a second tuner 522. For example, the third sensor 513 and the FPCB 280 may be electrically connected via a third connection path 503. For example, the second tuner 522 and the FPCB 280 may be electrically connected via a fourth connection path 504. For example, the second tuner 522, the FPCB 280, and the connector 207 may be electrically connected via a second signal path 532 and may transmit and/or receive a signal.

According to an embodiment, the third sensor 513 may be configured to detect the folding angle and/or the unfolding angle of the first housing 210 and the second housing 220. The third sensor 513 may be configured to transmit the detected folding angle and/or unfolding angle of the first housing 210 and the second housing 220 to the processor 120.

According to an embodiment, the second tuner 522 may be configured to compensate for (e.g., correct) an impedance of the FPCB 280 under control of the processor 120. The second tuner 522 may be configured to compensate for a change in impedance of the FPCB 280 caused by folding of the first housing 210 and the second housing 220. For example, the second tuner 522 may include at least one matching element (e.g., a capacitor and/or an inductor). The second tuner 522 may be configured to match an impedance difference of the FPCB 280 caused by folding of the first housing 210 and the second housing 220.

Referring to FIG. 11B, the second tuner 522 may include a switch 1101, a first matching circuit 1110, a second matching circuit 1120, and/or a third matching circuit 1130. The switch 1101 may electrically connect or disconnect the FPCB 120 and one of the first matching circuit 1110, the second matching circuit 1120, and the third matching circuit 1130. The first matching circuit 1110 may include a first inductor 1111 and a first capacitor 1112. The second matching circuit 1120 may include a second inductor 1121 and a second capacitor 1122. The third matching circuit 1130 may include a third capacitor 1133 and a third inductor 1134. For example, the matching values of the first matching circuit 1110, the second matching circuit 1120, and the third matching circuit 1130 may differ from each other. For example, the first matching circuit 1110 may have a first matching value. The second matching circuit 1120 may have a second matching value. The third matching circuit 1130 may have a third matching value. The processor 120 may be configured to control the second tuner 522 to apply a matching value (e.g., one of the first matching value, the second matching value, and the third matching value) corresponding to a change in impedance of the FPCB 280 to the FPCB 280.

According to various embodiments, the first matching circuit 1110, the second matching circuit 1120, or the third matching circuit 1130 of the second tuner 522 may be electrically connected to or disconnected from the FPCB 280 via the switch 1101. The switch 1101 may be electrically connected to one of the first matching circuit 1110, the second matching circuit 1120, and the third matching circuit 1130, which has a predetermined matching value, under the control of the processor 120. According to an embodiment, the switch 1101 may include one of a micro-electro mechanical system (MEMS) switch, a single pole single throw (SPST) switch, and a single pole double throw (SPDT) switch.

According to an embodiment, the hinge module 240 may be disposed between the first housing 210 and the second housing 220 and may be configured to allow the first housing 210 and the second housing 220 to rotate. The hinge module 240 may be disposed such that the first housing 210 and the second housing 220 are foldable and/or unfoldable about a folding axis (e.g., the folding axis F of FIG. 2A, FIG. 2B, FIG. 2C, FIG. 3A, and/or FIG. 3B). The hinge module 240 may have a first side coupled to at least a portion of the first housing 210 and a second side coupled to at least a portion of the second housing 220.

According to an embodiment, the FPCB 280 may electrically connect the first printed circuit board 261 and the second printed circuit board 262. At least a portion of the FPCB 280 may be disposed in the hinge module 240. The FPCB 280 may be disposed across the first housing 210 and the second housing 220 through the hinge module 240. Depending on the folded and/or unfolded state of the first housing 210 and the second housing 220, at least a portion of the FPCB 280 may be bent at a portion corresponding to the hinge module 240.

According to an embodiment, the connector 207 (e.g., a USB connector) may be disposed in the second housing 220. The connector 207 may be disposed in a portion of the second housing 220. The connector 207 may be electrically connected to the second printed circuit board 262 and the FPCB 280. The connector 207 may electrically connect the electronic device 200 to an external electronic device (e.g., a charging device). The electronic device 200 may be configured to transmit and receive a signal to and from an external electronic device (e.g., the external electronic devices 102 and 104 of FIG. 1) through the connector 207 (e.g., a USB connector).

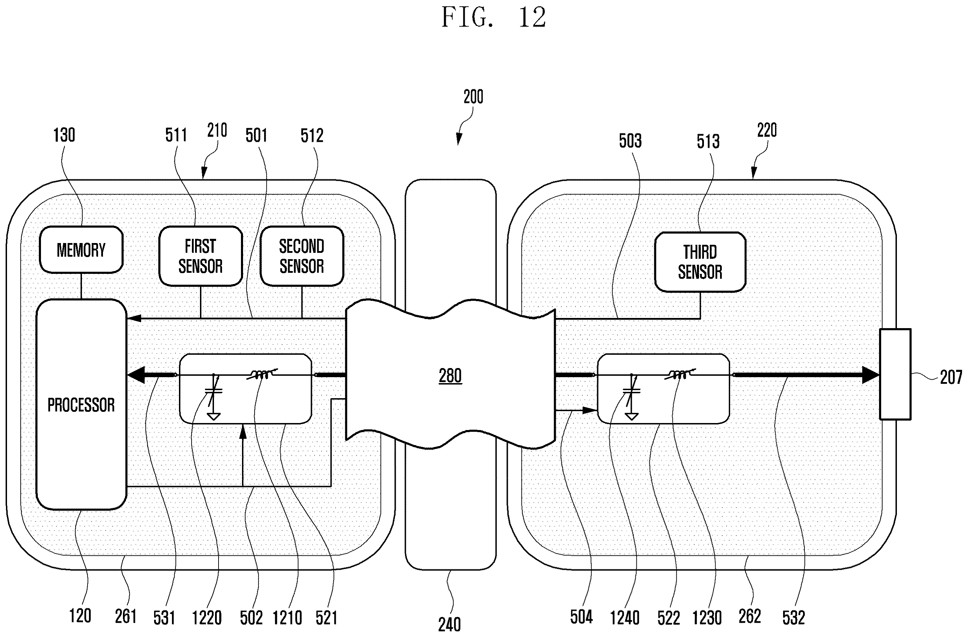

FIG. 12 is a view schematically illustrating some components of a first tuner and/or a second tuner of an electronic device (e.g., a foldable electronic device) according to an embodiment of the disclosure.

According to various embodiments, the electronic device 200 (e.g., a foldable electronic device) illustrated in FIG. 12 may include at least some embodiments of the electronic devices 101 and 200 disclosed in FIGS. 1 to 11B. In the description of FIG. 12, the same reference numerals may be assigned to components substantially identical to those described above with reference to the embodiments of FIGS. 5 to 11B, and redundant descriptions of their functions may be omitted.

Referring to FIG. 12, an electronic device 200 (e.g., a foldable electronic device) according to an embodiment of the disclosure may include a first housing 210, a second housing 220, a hinge module 240, an FPCB 280, and/or a connector 207.

According to an embodiment, the first housing 210 may be at least partially coupled to a first side of the hinge module 240. The first housing 210 may be configured to be foldable and unfoldable with the second housing 220 about the hinge module 240. The first housing 210 may include a first printed circuit board 261.

According to an embodiment, the first printed circuit board 261 may be disposed inside the first housing 210. The first printed circuit board 261 may include a first sensor 511, a second sensor 512, a first tuner 521, a memory 130, and/or a processor 120. For example, the first sensor 511, the second sensor 512, the processor 120, and the FPCB 280 may be electrically connected via a first connection path 501. For example, the first tuner 521, the processor 120, and the FPCB 280 may be electrically connected via a second connection path 502. For example, the first tuner 521, the processor 120, and the FPCB 280 may be electrically connected via a first signal path 531 and may transmit and/or receive a signal.

According to an embodiment, the first sensor 511 may be configured to detect a folding angle and/or an unfolding angle between the first housing 210 and the second housing 220. The first sensor 511 may be configured to detect an angle (e.g., a rotation angle) corresponding to the folded state and/or the unfolded state of the first housing 210 and the second housing 220 with respect to the hinge module 240. The first sensor 511 may be configured to deliver the detected folding angle and/or unfolding angle of the first housing 210 and the second housing 220 to the processor 120.

According to an embodiment, the second sensor 512 may be configured to detect an impedance change (e.g., an amount of change) of the FPCB 280 based on the folding angle and/or the unfolding angle between the first housing 210 and the second housing 220. The second sensor 512 may be configured to deliver the detected impedance change of the FPCB 280 to the processor 120. For example, the second sensor 512 may include an impedance detection circuit configured to detect a change in impedance of the FPCB 280 based on the folding angle and/or the unfolding angle between the first housing 210 and the second housing 220.

According to an embodiment, the first tuner 521 may be configured to compensate for (e.g., correct) an impedance of the FPCB 280 under control of the processor 120. The first tuner 521 may be configured to compensate for a change in impedance of the FPCB 280 caused by folding of the first housing 210 and the second housing 220. For example, the first tuner 521 may include at least one matching element (e.g., a capacitor and/or an inductor). The first tuner 521 may be configured to match an impedance difference of the FPCB 280 caused by folding of the first housing 210 and the second housing 220.

According to an embodiment, the first tuner 521 may include a first variable inductor 1210 and a first variable capacitor 1220. The processor 120 may be configured to control the first variable inductor 1210 and the first variable capacitor 1220 of the first tuner 521 to apply a matching value corresponding to a change in impedance of the FPCB 280 to the FPCB 280.

According to an embodiment, the memory 130 may be configured to store a matching value capable of matching an impedance difference of the FPCB 280 caused by folding of the first housing 210 and the second housing 220 and/or a configured value for compensating so as to maintain signal quality. The memory 130 may be configured to store a configured value related to a matching value and/or a compensation value capable of matching a mismatch in impedance of the FPCB 280 based on the folding angle and/or the unfolding angle of the first housing 210 and the second housing 220. The memory 130 may be configured to store a table related to a matching value and/or a configured value for compensating for an impedance of the FPCB 280 based on the folding angle and/or the unfolding angle of the first housing 210 and the second housing 220.

According to an embodiment, the processor 120 may be operatively connected to the first sensor 511, the second sensor 512, the first tuner 521, and the memory 130, which are disposed on the first printed circuit board 261. The processor 120 may be operatively connected to the third sensor 513, the second tuner 522, and the connector 207 (e.g., a USB connector), which are disposed on the second printed circuit board 262. The processor 120 may be configured to control functions and operations of the first tuner 521 and/or the second tuner 522 based on at least one instruction stored in the memory 130. The processor 120 may be configured to control a matching value of the first tuner 521 and/or a matching value of the second tuner 522 based on the folding angle and/or the unfolding angle of the first housing 210 and the second housing 220, so as to compensate for a change in impedance of the FPCB 280.

According to an embodiment, the second housing 220 may be at least partially coupled to a second side of the hinge module 240. The second housing 220 may be configured to be foldable and unfoldable with the first housing 210 around the hinge module 240. The second housing 220 may include the second printed circuit board 262. A portion of the second housing 220 may include a connector 207.

According to an embodiment, the second printed circuit board 262 may be disposed inside the second housing 220. The second printed circuit board 262 may include a third sensor 513 and/or a second tuner 522. For example, the third sensor 513 and the FPCB 280 may be electrically connected via a third connection path 503. For example, the second tuner 522 and the FPCB 280 may be electrically connected via a fourth connection path 504. For example, the second tuner 522, the FPCB 280, and the connector 207 may be electrically connected via a second signal path 532 and may transmit and/or receive a signal.

According to an embodiment, the third sensor 513 may be configured to detect the folding angle and/or the unfolding angle of the first housing 210 and the second housing 220. The third sensor 513 may be configured to transmit the detected folding angle and/or unfolding angle of the first housing 210 and the second housing 220 to the processor 120.

According to an embodiment, the second tuner 522 may be configured to compensate for (e.g., correct) an impedance of the FPCB 280 under control of the processor 120. The second tuner 522 may be configured to compensate for a change in impedance of the FPCB 280 caused by folding of the first housing 210 and the second housing 220. For example, the second tuner 522 may include at least one matching element (e.g., a capacitor and/or an inductor). The second tuner 522 may be configured to match an impedance difference of the FPCB 280 caused by folding of the first housing 210 and the second housing 220.

According to an embodiment, the second tuner 522 may include a second variable inductor 1230 and a second variable capacitor 1240. The processor 120 may be configured to control the second variable inductor 1230 and the second variable capacitor 1240 of the second tuner 522 to apply a matching value corresponding to a change in impedance of the FPCB 280 to the FPCB 280. According to various embodiments, the matching values of the first tuner 521 and the second tuner 522 may differ from each other.

According to an embodiment, the hinge module 240 may be disposed between the first housing 210 and the second housing 220 and may be configured to allow the first housing 210 and the second housing 220 to rotate. The hinge module 240 may be disposed such that the first housing 210 and the second housing 220 are foldable and/or unfoldable about a folding axis (e.g., the folding axis F of FIG. 2A, FIG. 2B, FIG. 2C, FIG. 3A, and/or FIG. 3B). The hinge module 240 may have a first side coupled to at least a portion of the first housing 210 and a second side coupled to at least a portion of the second housing 220.

According to an embodiment, the FPCB 280 may electrically connect the first printed circuit board 261 and the second printed circuit board 262. At least a portion of the FPCB 280 may be disposed in the hinge module 240. The FPCB 280 may be disposed across the first housing 210 and the second housing 220 through the hinge module 240. Depending on the folded and/or unfolded state of the first housing 210 and the second housing 220, at least a portion of the FPCB 280 may be bent at a portion corresponding to the hinge module 240.

According to an embodiment, the connector 207 (e.g., a USB connector) may be disposed in the second housing 220. The connector 207 may be disposed in a portion of the second housing 220. The connector 207 may be electrically connected to the second printed circuit board 262 and the FPCB 280. The connector 207 may electrically connect the electronic device 200 to an external electronic device (e.g., a charging device). The electronic device 200 may be configured to transmit and receive a signal to and from an external electronic device (e.g., the external electronic devices 102 and 104 of FIG. 1) through the connector 207 (e.g., a USB connector).

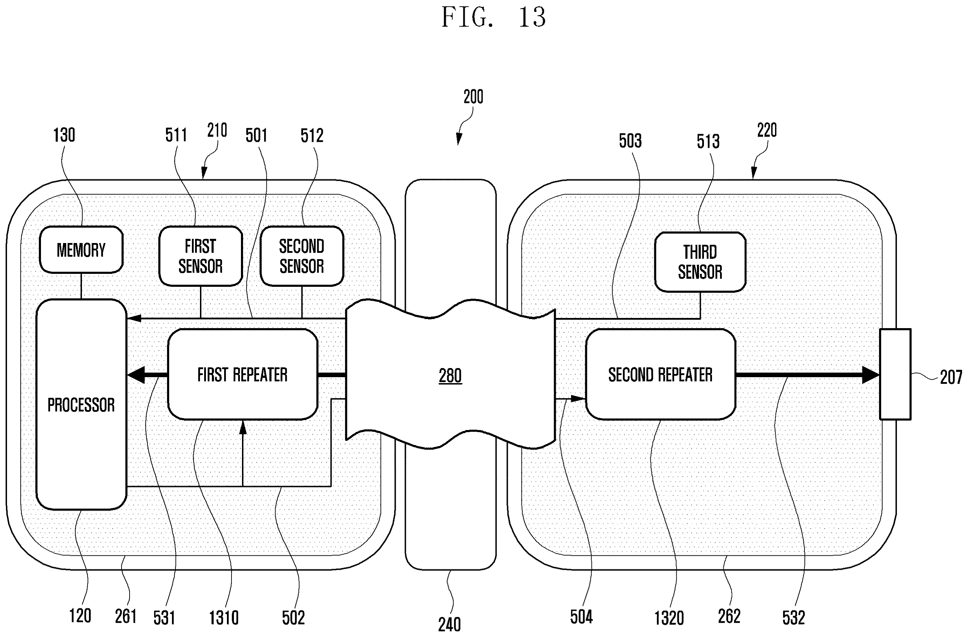

FIG. 13 is a view schematically illustrating some components of an electronic device (e.g., a foldable electronic device) including a repeater (e.g., a redriver) according to an embodiment of the disclosure.

According to various embodiments, the electronic device 200 (e.g., a foldable electronic device) illustrated in FIG. 13 may include at least some embodiments of the electronic devices 101 and 200 illustrated in FIGS. 1 to 12. In the description of FIG. 13, the same reference numerals are assigned to components that are substantially the same as those disclosed in FIGS. 5 to 12, and redundant descriptions of their functions may be omitted.

Referring to FIG. 13, an electronic device 200 (e.g., a foldable electronic device) according to an embodiment of the disclosure may include a first housing 210, a second housing 220, a hinge module 240, an FPCB 280, and/or a connector 207.

According to an embodiment, the first housing 210 may be at least partially coupled to a first side of the hinge module 240. The first housing 210 may be configured to be foldable and unfoldable with the second housing 220 about the hinge module 240. The first housing 210 may include a first printed circuit board 261.

According to an embodiment, the first printed circuit board 261 may be disposed inside the first housing 210. The first printed circuit board 261 may include a first sensor 511, a second sensor 512, a first repeater 1310, a memory 130, and/or a processor 120. For example, the first sensor 511, the second sensor 512, the processor 120, and the FPCB 280 may be electrically connected via a first connection path 501. For example, the first repeater 1310, the processor 120, and the FPCB 280 may be electrically connected via a second connection path 502. For example, the first repeater 1310, the processor 120, and the FPCB 280 may be electrically connected via a first signal path 531 and may transmit and/or receive a signal.

According to an embodiment, the first sensor 511 may be configured to detect a folding angle and/or an unfolding angle between the first housing 210 and the second housing 220. The first sensor 511 may be configured to detect an angle (e.g., a rotation angle) corresponding to the folded state and/or the unfolded state of the first housing 210 and the second housing 220 with respect to the hinge module 240. The first sensor 511 may be configured to deliver the detected folding angle and/or unfolding angle of the first housing 210 and the second housing 220 to the processor 120.

According to an embodiment, the second sensor 512 may be configured to detect an impedance change (e.g., an amount of change) of the FPCB 280 based on the folding angle and/or the unfolding angle between the first housing 210 and the second housing 220. The second sensor 512 may be configured to deliver the detected impedance change of the FPCB 280 to the processor 120. For example, the second sensor 512 may include an impedance detection circuit configured to detect a change in impedance of the FPCB 280 based on the folding angle and/or the unfolding angle between the first housing 210 and the second housing 220.

According to an embodiment, the first repeater 1310 (e.g., a first redriver) may be configured to transmit, to the FPCB 280, a matching value and/or a configured value for compensating for (e.g., correcting) the impedance of the FPCB 280 under the control of the processor 120. The first repeater 1310 may be configured to transmit, to the FPCB 280, the matching value and/or the configured value stored in the memory 130 under the control of the processor 120 and to compensate for a change in impedance of the FPCB 280. The first repeater 1310 may include a first redriver configured to transmit, to the FPCB 280, the matching value and/or the configured value stored in the memory 130. The first repeater 1310 may transmit, to the FPCB 280, a matching value corresponding to a change in impedance of the FPCB 280 caused by the folding of the first housing 210 and the second housing 220.

According to an embodiment, the memory 130 may be configured to store a matching value capable of matching an impedance difference of the FPCB 280 caused by folding of the first housing 210 and the second housing 220 and/or a configured value for compensating so as to maintain signal quality. The memory 130 may be configured to store a configured value related to a matching value and/or a compensation value capable of matching a mismatch in impedance of the FPCB 280 based on the folding angle and/or the unfolding angle of the first housing 210 and the second housing 220. The memory 130 may be configured to store a table related to a matching value and/or a configured value for compensating for an impedance of the FPCB 280 based on the folding angle and/or the unfolding angle of the first housing 210 and the second housing 220. The memory 130 may be configured to transmit, to the FPCB 280 via the first repeater 1310, a matching value and/or a configured value for compensating for (e.g., correcting) the impedance of the FPCB 280 under the control of the processor 120.

According to an embodiment, the processor 120 may be operatively connected to the first sensor 511, the second sensor 512, the first repeater 1310, and the memory 130, which are disposed on the first printed circuit board 261. The processor 120 may be operatively connected to the third sensor 513, the second repeater 1320, and the connector 207 (e.g., a USB connector), which are disposed on the second printed circuit board 262. The processor 120 may be configured to control functions and operations of the first repeater 1310 (e.g., a first redriver) and/or the second repeater 1320 (e.g., a second redriver), based on at least one instruction stored in the memory 130. The processor 120 may be configured to transmit, to the FPCB 280 via the first repeater 1310 and/or the second repeater 1320, a matching value and/or a configured value stored in the memory 130 based on a folding angle and/or an unfolding angle of the first housing 210 and the second housing 220.

According to an embodiment, the second housing 220 may be at least partially coupled to a second side of the hinge module 240. The second housing 220 may be configured to be foldable and unfoldable with the first housing 210 around the hinge module 240. The second housing 220 may include the second printed circuit board 262. A portion of the second housing 220 may include a connector 207.

According to an embodiment, the second printed circuit board 262 may be disposed inside the second housing 220. According to an embodiment, the second printed circuit board 262 may include a third sensor 513 and/or a second repeater 1320 (e.g., a second redriver). For example, the third sensor 513 and the FPCB 280 may be electrically connected via a third connection path 503. For example, the second repeater 1320 and the FPCB 280 may be electrically connected via a fourth connection path 504. For example, the second repeater 1320, the FPCB 280, and the connector 207 may be electrically connected via a second signal path 532 and may transmit and/or receive a signal.

According to an embodiment, the third sensor 513 may be configured to detect the folding angle and/or the unfolding angle of the first housing 210 and the second housing 220. The third sensor 513 may be configured to transmit the detected folding angle and/or unfolding angle of the first housing 210 and the second housing 220 to the processor 120.

According to an embodiment, the second repeater 1320 (e.g., a second redriver) may be configured to transmit, to the FPCB 280, a matching value and/or a configured value for compensating for (e.g., correcting) the impedance of the FPCB 280 under the control of the processor 120. The second repeater 1320 may be configured to transmit, to the FPCB 280, the matching value and/or the configured value stored in the memory 130 under the control of the processor 120 and to compensate for a change in impedance of the FPCB 280. The second repeater 1320 may include a second redriver configured to transmit, to the FPCB 280, the matching value and/or the configured value stored in the memory 130. The second repeater 1320 may be configured to match a change in impedance of the FPCB 280 caused by folding of the first housing 210 and the second housing 220.

According to an embodiment, the hinge module 240 may be disposed between the first housing 210 and the second housing 220 and may be configured to allow the first housing 210 and the second housing 220 to rotate. The hinge module 240 may be disposed such that the first housing 210 and the second housing 220 are foldable and/or unfoldable about a folding axis (e.g., the folding axis F of FIG. 2A, FIG. 2B, FIG. 2C, FIG. 3A, and/or FIG. 3B). The hinge module 240 may have a first side coupled to at least a portion of the first housing 210 and a second side coupled to at least a portion of the second housing 220.

According to an embodiment, the FPCB 280 may electrically connect the first printed circuit board 261 and the second printed circuit board 262. At least a portion of the FPCB 280 may be disposed in the hinge module 240. The FPCB 280 may be disposed across the first housing 210 and the second housing 220 through the hinge module 240. Depending on the folded and/or unfolded state of the first housing 210 and the second housing 220, at least a portion of the FPCB 280 may be bent at a portion corresponding to the hinge module 240.

According to an embodiment, the connector 207 (e.g., a USB connector) may be disposed in the second housing 220. The connector 207 may be disposed in a portion of the second housing 220. The connector 207 may be electrically connected to the second printed circuit board 262 and the FPCB 280. The connector 207 may electrically connect the electronic device 200 to an external electronic device (e.g., a charging device). The electronic device 200 may be configured to transmit and receive a signal to and from an external electronic device (e.g., the external electronic devices 102 and 104 of FIG. 1) through the connector 207 (e.g., a USB connector).

According to an embodiment of the disclosure, an electronic device 200 may include a hinge module 240, a first housing 210 coupled to at least a portion of a first side of the hinge module 240 and including a first printed circuit board 261, a second housing 220 coupled to at least a portion of a second side of the hinge module 240 and including a second printed circuit board 262, and a flexible printed circuit board (FPCB) 280 disposed across the first housing 210 and the second housing 220 through the hinge module 240 and configured to electrically connect the first printed circuit board 261 and the second printed circuit board 262. According to an embodiment, the electronic device 200 may include a first sensor 511 electrically connected to the first printed circuit board 261 to detect a folding angle or an unfolding angle of the first housing 210 and the second housing 220. According to an embodiment, the electronic device 200 may include a second sensor 512 electrically connected to the first printed circuit board 261 to detect a change in impedance of the FPCB 280 based on the folding angle or the unfolding angle of the first housing 210 and the second housing 220. According to an embodiment, the electronic device 200 may include a first tuner 521 disposed on the first printed circuit board 261 to compensate for the change in impedance of the FPCB 280 generated by folding of the first housing 210 and the second housing 220. According to an embodiment, the electronic device 200 may include a processor 120 operatively connected to the FPCB 280, the first sensor 511, the second sensor 512, and the first tuner 521. According to an embodiment, the processor 120 may be configured to control the first tuner 521 based on the folding angle or the unfolding angle of the first housing 210 and the second housing 220 so as to compensate for the change in impedance of the FPCB 280.

According to an embodiment, the electronic device 200 may include a memory 130 configured to store a matching value for compensating for the change in impedance of the FPCB 280 based on the folding angle or the unfolding angle of the first housing 210 and the second housing 220.

According to an embodiment, the electronic device 200 may include a connector 207 disposed in the second housing 220 and electrically connected to the FPCB 280 to transmit and receive signals to and receive from an external electronic device.

According to an embodiment, the electronic device 200 may include a third sensor 513 electrically connected to the second printed circuit board 262 to detect a folding angle or an unfolding angle of the first housing 210 and the second housing 220.

According to an embodiment, the electronic device 200 may include a second tuner 522 disposed on the second printed circuit board 262 to compensate for the change in impedance of the FPCB 280 generated by folding of the first housing 210 and the second housing 220.

According to an embodiment, the electronic device 200 may include a first connector 610 configured to electrically connect a first side of the FPCB 280 to the first printed circuit board 261, and a second connector 620 configured to electrically connect a second side of the FPCB 280 to the second printed circuit board 262.

According to an embodiment, the electronic device 200 may include a first IC 710 disposed on the first printed circuit board 261, and a second IC 720 disposed on the second printed circuit board 262.

According to an embodiment, the first sensor 511 and the third sensor 513 may each include a motion sensor configured to detect the folding angle or the unfolding angle of the first housing 210 and the second housing 220 based on gravitational acceleration corresponding to a folded state or an unfolded state of the first housing 210 and the second housing 220.

According to an embodiment, the hinge module 240 may include at least one gear 810, and the first sensor 511 may include a gear counter configured to count a number of rotations of the at least one gear 810.

According to an embodiment, the processor 120 may be configured to detect the folding angle or the unfolding angle of the first housing 210 and the second housing 220 based on the number of rotations of the at least one gear 810.

According to an embodiment, the second housing 220 may include a magnet 910, the first sensor 511 may include a Hall sensor configured to sense a magnetic force of the magnet 910, and the processor 120 may be configured to detect the folding angle or the unfolding angle of the first housing 210 and the second housing 220 based on magnetic force information sensed through the first sensor 511 and the magnet 910.

According to an embodiment, the first sensor 511 may include an image sensor configured to sense an image corresponding to a folded state or an unfolded state of the second housing 220 with respect to the first housing 210.

According to an embodiment, the first tuner 521 may include a switch 1101, a first matching circuit 1110 having a first matching value, and a second matching circuit 1120 having a second matching value, and the processor 120 may be configured to electrically connect or disconnect the switch 1101 to or from the first matching circuit 1110 or the second matching circuit 1120.

According to an embodiment, the processor 120 may be configured to control the first tuner 521 so as to apply the first matching value or the second matching value to the FPCB 280.

According to an embodiment, the first matching circuit 1110 may include a first inductor 1111 and a first capacitor 1112, and the second matching circuit 1120 may include a second inductor 1121 and a second capacitor 1122.

According to an embodiment, the first matching value and the second matching value may be configured to be different from each other.

According to an embodiment, the second tuner 522 may include a switch 1101, a first matching circuit 1110 having a first matching value, and a second matching circuit 1120 having a second matching value, and the first matching value and the second matching value may be configured to be different from each other.

According to an embodiment, the first tuner 521 may include a first variable inductor 1210 and a first variable capacitor 1220, and the processor 120 may be configured to control the first variable inductor 1210 and the first variable capacitor 1220 so as to apply a matching value corresponding to a change in impedance of the FPCB 280 to the FPCB 280.

According to an embodiment, the second tuner 522 may include a second variable inductor 1230 and a second variable capacitor 1240, and the processor 120 may be configured to control the second variable inductor 1230 and the second variable capacitor 1240 so as to apply the matching value corresponding to the change in impedance of the FPCB 280 to the FPCB 280.

According to an embodiment, the first printed circuit board 261 may further include a first repeater 1310, and the processor 120 may be configured to deliver the matching value stored in the memory to the FPCB 280 via the first repeater 1310.

In the foregoing, the disclosure has been described with reference to various embodiments of the disclosure, but it is evident that changes and modifications made by a person ordinarily skilled in the art to which the disclosure belongs without departing from the technical spirit of the disclosure fall within the scope of the disclosure.

## Claims

1. An electronic device (200) comprising:
a hinge module (240);
a first housing (210) coupled to at least a portion of a first side of the hinge module (240), the first housing (210) comprising a first printed circuit board (261);
a second housing (220) coupled to at least a portion of a second side of the hinge module (240), the second housing (220) comprising a second printed circuit board (262);
a flexible printed circuit board (FPCB) (280) disposed across the first housing (210) and the second housing (220) through the hinge module (240), the FPCB (280) being configured to electrically connect the first printed circuit board (261) and the second printed circuit board (262);
a first sensor (511) electrically connected to the first printed circuit board (261), the first sensor (511) being configured to detect a folding angle or an unfolding angle of the first housing (210) and the second housing (220);
a second sensor (512) electrically connected to the first printed circuit board (261), the second sensor (512) configured to detect a change in impedance of the FPCB (280) based on the folding angle or the unfolding angle of the first housing (210) and the second housing (220);
a first tuner (521) disposed on the first printed circuit board (261), the first tuner (521) being configured to compensate for the change in impedance of the FPCB (280) generated by folding of the first housing (210) and the second housing (220); and
a processor (120) operatively connected to the FPCB (280), the first sensor (511), the second sensor (512), and the first tuner (521),
wherein the processor (120) is configured to control the first tuner (521) based on the folding angle or the unfolding angle of the first housing (210) and the second housing (220) so as to compensate for the change in impedance of the FPCB (280).

2. The electronic device of claim 1, further comprising:
a memory (130) configured to store a matching value for compensating for the change in impedance of the FPCB (280) based on the folding angle or the unfolding angle of the first housing (210) and the second housing (220).

3. The electronic device of claim 1 or 2, further comprising:
a connector (207) disposed in the second housing (220) and electrically connected to the FPCB (280), the connector (207) being to transmit and receive a signal to and from an external electronic device.

4. The electronic device of any one of claims 1 to 3, further comprising:
a third sensor (513) electrically connected to the second printed circuit board (262), the third sensor (513) being configured to detect the folding angle or the unfolding angle of the first housing (210) and the second housing (220).

5. The electronic device of any one of claims 1 to 4, further comprising:
a second tuner (522) disposed on the second printed circuit board (262), the second tuner (522) being configured to compensate for the change in impedance of the FPCB (280) generated by folding of the first housing (210) and the second housing (220).

6. The electronic device of any one of claims 1 to 5, further comprising:
a first connector (610) configured to electrically connect a first side of the FPCB (280) to the first printed circuit board (261); and
a second connector (620) configured to electrically connect a second side of the FPCB (280) to the second printed circuit board (262).

7. The electronic device of any one of claims 1 to 6, further comprising:
a first IC (710) disposed on the first printed circuit board (261); and
a second IC (720) disposed on the second printed circuit board (262).

8. The electronic device of claim 4, wherein the first sensor (511) and the third sensor (513) each comprise a motion sensor configured to detect the folding angle or the unfolding angle of the first housing (210) and the second housing (220) based on gravitational acceleration corresponding to a folded state or an unfolded state of the first housing (210) and the second housing (220).

9. The electronic device of claim 1, wherein the first sensor (511) and the second sensor (512) are disposed on the first printed circuit board (261).

10. The electronic device of claim 1, wherein the hinge module (240) comprises at least one gear (810),
wherein the first sensor (511) comprises a gear counter configured to count a number of rotations of the at least one gear (810), and
wherein the processor (120) is configured to detect the folding angle or the unfolding angle of the first housing (210) and the second housing (220) based on the number of rotations of the at least one gear (810).

11. The electronic device of claim 1, wherein the second housing (220) comprises a magnet (910),
wherein the first sensor (511) comprises a Hall sensor configured to sense a magnetic force of the magnet (910), and
wherein the processor (120) is configured to detect the folding angle or the unfolding angle of the first housing (210) and the second housing (220) based on magnetic force information sensed through the first sensor (511) and the magnet (910).

12. The electronic device of claim 1, wherein the first sensor (511) comprises an image sensor configured to sense an image corresponding to a folded state or an unfolded state of the second housing (220) with respect to the first housing (210).

13. The electronic device of claim 1, wherein the first tuner (521) comprises a switch (1101), a first matching circuit (1110) having a first matching value, and a second matching circuit (1120) having a second matching value, and
wherein the processor (120) is configured to electrically connect or disconnect the switch (1101) to or from the first matching circuit (1110) or the second matching circuit (1120).

14. The electronic device of claim 13, wherein the processor (120) is configured to control the first tuner (521) so as to apply the first matching value or the second matching value to the FPCB (280).

15. The electronic device of claim 13 or 14, wherein the first matching circuit (1110) comprises a first inductor (1111) and a first capacitor (1112), and
wherein the second matching circuit (1120) comprises a second inductor (1121) and a second capacitor (1122).
